(19) Europäisches Patentamt
European Patent Office
Office européen des brevets

(11) EP 3 270 431 A1

(12) EUROPEAN PATENT APPLICATION
published in accordance with Art. 153(4) EPC

(43) Date of publication:
**17.01.2018 Bulletin 2018/03**

(21) Application number: **16761478.3**

(22) Date of filing: **23.02.2016**

(51) Int Cl.:
***H01L 51/44*** *(2006.01)* ***H01G 9/20*** *(2006.01)*

(86) International application number:
**PCT/JP2016/055236**

(87) International publication number:
**WO 2016/143506 (15.09.2016 Gazette 2016/37)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **09.03.2015 JP 2015046440**

(71) Applicant: **FUJIFILM Corporation**
**Tokyo 106-8620 (JP)**

(72) Inventors:
- **SATOU, Hirotaka**
**Ashigarakami-gun**
**Kanagawa 258-8577 (JP)**
- **KOBAYASHI, Katsumi**
**Ashigarakami-gun**
**Kanagawa 258-8577 (JP)**

(74) Representative: **Hoffmann Eitle**
**Patent- und Rechtsanwälte PartmbB**
**Arabellastraße 30**
**81925 München (DE)**

# (54) PHOTOELECTRIC CONVERSION ELEMENT, SOLAR CELL, AND METHOD FOR PRODUCING PHOTOELECTRIC CONVERSION ELEMENT

(57) Provided are a photoelectric conversion element including a first electrode having a photosensitive layer including a light absorber on a conductive support and a second electrode facing the first electrode, in which the light absorber includes a compound having a perovskite-type crystal structure, and a compound represented by a specific formula is provided on a surface of the first electrode, a solar cell using the same, and a method for manufacturing a photoelectric conversion element including bringing a first electrode having a photosensitive layer in which a compound having a specific perovskite-type crystal structure is included as a light absorber on a conductive support into contact with a liquid containing a compound represented by specific Formula (AC).

FIG. 1

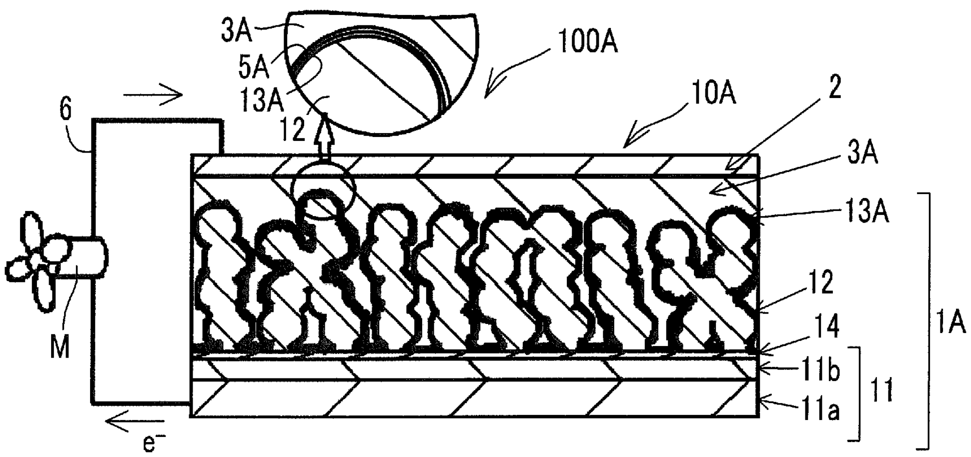




Printed by Jouve, 75001 PARIS (FR)

## Description

### BACKGROUND OF THE INVENTION

1. Field of the Invention

The present invention relates to a photoelectric conversion element, a solar cell, and a method for manufacturing a photoelectric conversion element.

2. Description of the Related Art

Photoelectric conversion elements are used in a variety of optical sensors, copiers, solar cells, and the like. It is anticipated that solar cells will be actively put into practical use as cells using non-exhaustible solar energy. Among them, in recent years, solar cells in which a metallic halide such as a compound having a perovskite-type crystal structure (hereinafter, in some cases, referred to as perovskite compound) is used as a light absorber have been attracting attention.

Research results that these solar cells are capable of achieving a relatively high photoelectric conversion efficiency have been reported. For example, ACS Nano, DOI: 10. 1021/nn5036476 describes that the power conversion efficiency is improved by means of passivation of the crystal surface of a perovskite compound represented by $CH_3NH_3PbI_{3-x}Cl_x$ with thiophene or pyridine.

### SUMMARY OF THE INVENTION

For solar cells in which a perovskite compound is used as a light absorber, there is a demand for durability which suppresses the degradation of initial performance even after time has elapsed in addition to favorable initial performance (for example, short-circuit currents (also simply referred to as currents), open voltage, and photoelectric conversion efficiency). However, perovskite compounds are not sufficiently stable. Solar cells in which a perovskite compound is used as a light absorber degrade in terms of initial performance as time elapses. Since solar cells in which a perovskite compound is used as a light absorber have been recently developed, cell performance has not yet been sufficiently researched and studied.

Therefore, an object of the present invention is to provide a photoelectric conversion element in which a perovskite compound is used as a light absorber and durability is excellent and a solar cell using this photoelectric conversion element. In addition, another object of the present invention is to provide a method for manufacturing a photoelectric conversion element exhibiting excellent durability even when a perovskite compound is used as a light absorber.

The present inventors found that, when a specific compound is provided on the surface of a photosensitive layer including a perovskite compound in photoelectric conversion elements or solar cells in which the perovskite compound is used as a light absorber, photoelectric conversion elements or solar cells having initial performances, particularly, current values that do not easily decrease can be obtained. The present invention has been completed by further repeating studies on the basis of the above-described finding.

That is, the above-described objects have been achieved by the following means.

<1> A photoelectric conversion element comprising: a first electrode having a photosensitive layer including a light absorber on a conductive support; and a second electrode facing the first electrode, in which the light absorber includes a compound having a perovskite-type crystal structure including cations of an element belonging to Group I of the periodic table or a cationic organic group A, cations of a metallic atom M other than elements belonging to Group I of the periodic table, and anions of an anionic atom or atomic group X, and a compound represented by Formula (AC) is provided on a surface of the first electrode.

Formula (AC)

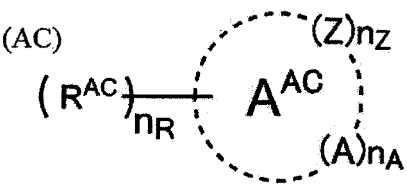

In the formula, a ring $A^{AC}$ represents a hetero ring. Z represents a sulfur atom or an oxygen atom. $n_z$ represents an integer of 1 or more. A represents $>C=CR^{Y1}R^{Y2}$, $>C=S$, $>C=O$, or $>C=NR^{Y3}$. $R^{Y1}$ and $R^{Y2}$ each independently represent a substituent. $RY^3$ represents a hydrogen atom or substituent. $n_A$ represents an integer of 0 or more. $R^{AC}$ represents a substituent. $n_R$ represents an integer of 0 or more. Here, when Z is a sulfur atom, and $n_z$ is 1, $n_R$ represents

an integer of 1 or more.

<2> The photoelectric conversion element according to <1>, in which $R^{AC}$ is a halogen atom, an alkyl group having 5 or more carbon atoms, or a group having a halogen atom.

<3> The photoelectric conversion element according to <1> or <2>, in which the ring $A^{AC}$ is a five-membered or six-membered aromatic hetero ring.

<4> The photoelectric conversion element according to any one of <1> to <3>, in which at least one Z is an oxygen atom.

<5> The photoelectric conversion element according to any one of <1> to <4>, in which the ring $A^{AC}$ is a furan ring.

<6> The photoelectric conversion element according to any one of <1> to <5>, in which the compound having a perovskite-type crystal structure is a compound represented by Formula (I).

Formula (I): $A_aM_mX_x$

In the formula, A represents an element belonging to Group I of the periodic table or a cationic organic group represented by Formula (1). M represents a metallic atom other than elements belonging to Group I of the periodic table. X represents an anionic atom or atomic group. a represents 1 or 2, m represents 1, and a, m, and x satisfy a+2m=x.

Formula (1): $R^{1a}\text{-}NH_3$

In the formula, $R^{1a}$ represents a substituent.

<7> The photoelectric conversion element according to <6>, in which $R^{1a}$ is an alkyl group, a cycloalkyl group, an alkenyl group, an alkynyl group, an aryl group, a heteroaryl group, or a group that Formula (2) is capable of representing.

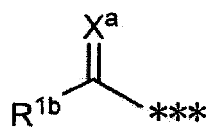

Formula (2)

In the formula, $X^a$ represents $NR^{1c}$, an oxygen atom, or a sulfur atom. $R^{1b}$ and $R^{1c}$ each independently represent a hydrogen atom or a substituent. *** represents a bond with a nitrogen atom in Formula (1).

<8> The photoelectric conversion element according to any one of <1> to <7>, in which the metallic atom is at least one metallic atom selected from the group consisting of lead and tin.

<9> The photoelectric conversion element according to any one of <1> to <8>, further comprising: a hole transport layer between the first electrode and the second electrode.

<10> The photoelectric conversion element according to any one of <1> to <9>, further comprising: a porous layer between the conductive support and the photosensitive layer.

<11> A solar cell using the photoelectric conversion element according to any one of <1> to <10>.

<12> A method for manufacturing a photoelectric conversion element, comprising: bringing a first electrode having a photosensitive layer in which a compound having a perovskite-type crystal structure having cations of an element belonging to Group I of the periodic table or a cationic organic group A, cations of a metallic atom M other than elements belonging to Group I of the periodic table, and anions of an anionic atom or atomic group X is included as a light absorber on a conductive support into contact with a liquid containing a compound represented by Formula (AC).

Formula (AC)

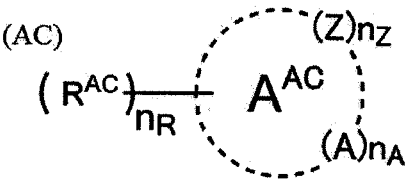

In the formula, a ring $A^{AC}$ represents a hetero ring. Z represents a sulfur atom or an oxygen atom. $n_Z$ represents an integer of 1 or more. A represents $>C=CR^{Y1}R^{Y2}$, $>C=S$, $>C=O$, or $>C=NR^{Y3}$. $R^{Y1}$ and $R^{Y2}$ each independently represent a substituent. $RY^3$ represents a hydrogen atom or substituent. $n_A$ represents an integer of 0 or more. $R^{AC}$ represents a substituent. $n_R$ represents an integer of 0 or more. Here, when Z is a sulfur atom, and $n_z$ is 1, $n_R$ represents an integer of 1 or more.

In the present specification, regarding the expressions of individual formulae, there are cases in which a part of the formula is expressed as a rational formula for understanding of the chemical structures of compounds. Accordingly, in the individual formulae, partial structures are called groups (substituents), ions, atoms, or the like; however, in the present specification, there are cases in which the partial structures will refer to element groups or elements constituting groups (substituents) or ions represented by the above-illustrated formulae in addition to groups (substituents), ions, atoms, or the like.

In the present specification, the expressions of compounds (also complexes and dyes) are used to indicate not only the compounds themselves but also salts or ions thereof. Furthermore, compounds that are not clearly described as being substituted or unsubstituted refer to compounds having an arbitrary substituent as long as intended effects are not impaired. What has been described above is also true for substituents, linking groups, and the like (hereinafter, also referred to as substituents and the like).

In the present specification, when there are a plurality of substituents and the like expressed using a specific reference symbol or a plurality of substituents and the like are specified at the same time, the respective substituents and the like may be identical to or different from each other unless particularly otherwise described. What has been described above is also true for the specification regarding the number of substituents and the like. In addition, when a plurality of substituents and the like are close to each other (particularly, when adjacent to each other), unless particularly otherwise described, the substituents and the like may be linked to each other and form a ring. Furthermore, rings, for example, alicycles, aromatic rings, and hetero rings may be further fused together and thus form a fused ring.

In addition, in the present specification, numerical ranges expressed using "to" include numerical values before and after the "to" as the lower limit value and the upper limit value.

The photoelectric conversion element and the solar cell of the present invention have excellent durability even when a perovskite compound is used as a light absorber. In addition, according to the method for manufacturing a photoelectric conversion element of the present invention, it is possible to manufacture photoelectric conversion elements having excellent durability even when a perovskite compound is used as a light absorber.

The above-described and other characteristics and advantages of the present invention will be further clarified from the following description with appropriate reference to the accompanying drawings.

## BRIEF DESCRIPTION OF THE DRAWINGS

Fig. 1 is a cross sectional view schematically illustrating a preferred aspect of a photoelectric conversion element of the present invention, including an enlarged view of a circular portion in the layer.

Fig. 2 is a cross sectional view schematically illustrating a preferred aspect of the photoelectric conversion element of the present invention including a thick photosensitive layer.

Fig. 3 is a cross sectional view schematically illustrating another preferred aspect of the photoelectric conversion element of the present invention, including an enlarged view of a circular portion in the layer.

Fig. 4 is a cross sectional view schematically illustrating still another preferred aspect of the photoelectric conversion element of the present invention.

Fig. 5 is a cross sectional view schematically illustrating far still another preferred aspect of the photoelectric conversion element of the present invention.

Fig. 6 is a cross sectional view schematically illustrating far still another preferred aspect of the photoelectric conversion element of the present invention, including an enlarged view of a circular portion in the layer.

## DESCRIPTION OF THE PREFERRED EMBODIMENTS

«Photoelectric conversion element»

A photoelectric conversion element of the present invention has a first electrode having a photosensitive layer including a light absorber on a conductive support and a second electrode facing the first electrode. The first electrode has a compound represented by Formula (AC) (in some cases, referred to as compound AC) on the surface.

In the present invention, "having the photosensitive layer on the conductive support" means that the photosensitive layer is provided in contact with the surface of the conductive support or the photosensitive layer is provided above the surface of the conductive support through another layer.

In the aspect in which the photosensitive layer is provided above the surface of the conductive support through another layer, the layer provided between the conductive support and the photosensitive layer is not particularly limited as long as the layer does not degrade the cell performance of solar cells. Examples thereof include a porous layer, a blocking layer, an electron transport layer, a hole transport layer, and the like.

In the present invention, examples of the aspect in which the photosensitive layer is provided above the surface of the conductive support through another layer include an aspect in which the photosensitive layer is provided on the surface of a porous layer in a thin film shape or the like (refer to Fig. 1), an aspect in which the photosensitive layer is provided on the surface of a porous layer in a thick film shape (refer to Figs. 2 and 6), an aspect in which the photosensitive layer is provided on the surface of a blocking layer in a thin film shape, an aspect in which the photosensitive layer is provided on the surface of a blocking layer in a thick film shape (refer to Fig. 3), an aspect in which the photosensitive layer is provided on the surface of an electron transport layer in a thin film shape or thick film shape (refer to Fig. 4), and an aspect in which the photosensitive layer is provided on the surface of a hole transport layer in a thin film shape or thick film shape (refer to Fig. 5). The photosensitive layer may be provided in a linear shape or in a dispersed pattern, but is preferably provided in a film shape.

In addition, in the present invention, "the surface of the first electrode" refers to a layer forming the surface of the first electrode, for example, the surface of the photosensitive layer provided in the first electrode on the second electrode side.

In the present invention, "having the compound AC on the surface of the first electrode" means that the compound AC is present on or near the surface of the first electrode. Aspects of the compound AC being presents include an aspect in which the compound AC is bonded, adhered, fixed, or adsorbed to or supported by the surface of the first electrode using chemical bonds or physical interactions. Examples thereof include all aspects of an aspect in which the compound AC is bonded to the surface of the first electrode using a covalent bond, an ionic bond, or a coordinate bond and an aspect in which the compound AC is physically adsorbed to the surface of the first electrode. In the present invention, how the compound AC is present on the surface of the first electrode does not matter as long as the compound AC is present on or near the surface of the first electrode. Therefore, the compound AC may be present, for example, in pores in the porous layer, or some of the compound AC may be incorporated into the photosensitive layer.

The compound AC needs to be present on the surface of the first electrode and may be in any state of a film shape, a linear shape, and a dispersed pattern or a mixed state thereof. In the present invention, regardless of the state of the compound AC on the surface of the first electrode, aggregation of the compound AC on the surface of the first electrode is referred to as a layer of the compound AC (compound layer) for convenience. Therefore, the compound layer does not essentially need to form a layer or film so as to uniformly cover the surface of the first electrode. Therefore, in the respective drawings, the compound AC is illustrated to be in a layer form as the presence state for easy understanding, but the presence state is not limited thereto.

There is no particular limitation regarding constitutions other than constitutions specified in the present invention for the photoelectric conversion element of the present invention, and well-known constitutions relating to photoelectric conversion elements and solar cells can be employed. Individual layers constituting the photoelectric conversion element of the present invention are designed according to their purposes and may be formed in, for example, a monolayer or multilayers.

Hereinafter, preferred aspects of the photoelectric conversion element of the present invention will be described.

In Figs. 1 to 6, the same reference symbol indicates the same constituent element (member).

Meanwhile, in Figs. 1, 2, and 6, fine particles forming a porous layer 12 are illustrated in an enlarged manner. These fine particles are preferably jammed with each other (accumulated or in close contact with each other) in the horizontal direction and the vertical direction with respect to a conductive support 11 and thus form a porous structure.

In the present specification, in the case of being simply described, a photoelectric conversion element 10 refers to photoelectric conversion elements 10A to 10F unless particularly otherwise described. This is also true for a system 100 and a first electrode 1. In addition, in the case of being simply described, a photosensitive layer 13 and a compound layer 5 respectively refer to photosensitive layers 13A to 13C and compound layers 5A to 5C unless particularly otherwise described. Similarly, in the case of being described, a hole transport layer 3 refers to hole transport layers 3A and 3B

unless particularly otherwise described.

Examples of the preferred aspects of the photoelectric conversion element of the present invention include the photoelectric conversion element 10A illustrated in Fig. 1. A system 100A illustrated in Fig. 1 is a system in which the photoelectric conversion element 10A is applied as a cell that causes action means M (for example, an electric motor) to operate through an external circuit 6.

The photoelectric conversion element 10A includes a first electrode 1A, the compound layer 5A on the photosensitive layer 13A in the first electrode 1A (refer to an enlarged portion A in Fig. 1), a second electrode 2, and the hole transport layer 3A between the first electrode 1A and the second electrode 2.

The first electrode 1A includes the conductive support 11 made up of a support 11 a and a transparent electrode 11b, the porous layer 12, and the photosensitive layer 13A on the porous layer 12. In addition, a blocking layer 14 is provided on the transparent electrode 11b, and the porous layer 12 is formed on the blocking layer 14. In the photoelectric conversion element 10A including the porous layer 12 as described above, since the surface area of the photosensitive layer 13A increases, it is assumed that the charge separation and charge transfer efficiency improves.

The photoelectric conversion element 10B illustrated in Fig. 2 is a schematic illustration of a preferred aspect in which the photosensitive layer 13A in the photoelectric conversion element 10A illustrated in Fig. 1 is provided to be thick. In Fig. 2, the compound layer in the photoelectric conversion element 10B is the same as the compound layer 5A in the photoelectric conversion element 10A illustrated in Fig. 1, and thus an enlarged view of the compound layer is not provided. In this photoelectric conversion element 10B, the hole transport layer 3B is provided to be thin. The photoelectric conversion element 10B is different from the photoelectric conversion element 10A illustrated in Fig. 1 in terms of the film thicknesses of the photosensitive layer 13B and the hole transport layer 3B, but is constituted in the same manner as the photoelectric conversion element 10A except for the film thicknesses.

The photoelectric conversion element 10C illustrated in Fig. 3 is a schematic illustration of another preferred aspect of the photoelectric conversion element of the present invention (the compound layer 5B is illustrated in an enlarged view A in Fig. 3). The photoelectric conversion element 10C is different from the photoelectric conversion element 10B illustrated in Fig. 2 in terms of the porous layer 12 not being provided, but is constituted in the same manner as the photoelectric conversion element 10B except for what has been described above. That is, in the photoelectric conversion element 10C, the photosensitive layer 13C is formed on the surface of the blocking layer 14 in a thick film shape, and the compound layer 5B is formed on the surface of the photosensitive layer 13C. In the photoelectric conversion element 10C, similar to the hole transport layer 3A, the hole transport layer 3B can also be provided to be thick.

The photoelectric conversion element 10D illustrated in Fig. 4 is a schematic illustration of still another preferred aspect of the photoelectric conversion element of the present invention. In Fig. 4, the compound layer in the photoelectric conversion element 10D is the same as the compound layer 5B in the photoelectric conversion element 10C illustrated in Fig. 3, and thus an enlarged view of the compound layer is not provided. The photoelectric conversion element 10D is different from the photoelectric conversion element 10C illustrated in Fig. 3 in terms of the provision of an electron transport layer 15 instead of the blocking layer 14, but is constituted in the same manner as the photoelectric conversion element 10C except for what has been described above. The first electrode 1D has the conductive support 11 and the electron transport layer 15 and the photosensitive layer 13C which are sequentially formed on the conductive support 11. This photoelectric conversion element 10D is preferred since the respective layers can be formed using organic materials. Therefore, the productivity of the photoelectric conversion element improves, and furthermore, it is possible to reduce the thickness or make the photoelectric conversion element flexible.

The photoelectric conversion element 10E illustrated in Fig. 5 is a schematic illustration of far still another preferred aspect of the photoelectric conversion element of the present invention. In Fig. 5, the compound layer in the photoelectric conversion element 10E is the same as the compound layer 5B in the photoelectric conversion element 10C illustrated in Fig. 3 except for the fact that the electron transport layer 4 is formed on the surface thereof instead of the hole transport layer 3B, and thus an enlarged view of the compound layer is not provided. A system 100E including the photoelectric conversion element 10E is, similar to the system 100A, a system that is applied as a cell.

The photoelectric conversion element 10E has a first electrode 1E, the second electrode 2, and the electron transport layer 4 between the first electrode 1E and the second electrode 2. The first electrode 1E has the conductive support 11 and the hole transport layer 16 and the photosensitive layer 13C which are sequentially formed on the conductive support 11. This photoelectric conversion element 10E is preferred since, similar to the photoelectric conversion element 10D, the respective layers can be formed using organic materials.

The photoelectric conversion element 10F illustrated in Fig. 6 is a schematic illustration of far still another preferred aspect of the photoelectric conversion element of the present invention (the compound layer 5C is illustrated in the enlarged portion A of Fig. 6). The photoelectric conversion element 10F is different from the photoelectric conversion element 10B illustrated in Fig. 2 in terms of the hole transport layer 3B being not provided, but is constituted in the same manner as the photoelectric conversion element 10B except for what has been described above.

In the present invention, the system 100 to which the photoelectric conversion element 10 is applied functions as a solar cell in the following manner.

That is, in the photoelectric conversion element 10, light that has passed through the conductive support 11 or the second electrode 2 and has entered the photosensitive layer 13 excites the light absorber. The excited light absorber has high-energy electrons and is capable of emitting the electrons. The light absorber which has emitted high-energy electrons turns into an oxidant.

In the photoelectric conversion elements 10A to 10D and 10F, electrons emitted from the light absorber migrate among light absorber particles and reach the conductive support 11. The electrons that have reached the conductive support 11 do their work in the external circuit 6 and then return to the photosensitive layer 13 through the second electrode 2 (in a case in which the hole transport layer 3 is provided, through the hole transport layer 3 in addition to the second electrode). The light absorber is reduced by the electrons which have returned to the photosensitive layer 13.

Meanwhile, in the photoelectric conversion element 10E, electrons emitted from the light absorber reach the second electrode 2 from the photosensitive layer 13C through the electron transport layer 4, do their work in the external circuit 6, and then return to the photosensitive layer 13 through the conductive support 11. The light absorber is reduced by the electrons which have returned to the photosensitive layer 13.

In the photoelectric conversion element 10, the system 100 functions as a solar cell by repeating the cycle of the above-described excitation of the light absorber and electron migration.

In the photoelectric conversion elements 10A to 10D and 10F, the flow direction of electrons from the photosensitive layer 13 to the conductive support 11 varies depending on the presence or absence, kind, and the like of the porous layer 12. In the photoelectric conversion element 10 of the present invention, electron conduction in which electrons migrate among the light absorber particles occurs. Therefore, in a case in which the porous layer 12 is provided, the porous layer 12 can be formed of an insulating body other than semiconductors in the related art. In a case in which the porous layer 12 is formed of a semiconductor, electron conduction in which electrons migrate inside or among semiconductor fine particles in the porous layer 12 also occurs. On the other hand, in a case in which the porous layer 12 is formed of an insulating body, electron conduction does not occur in the porous layer 12. In a case in which the porous layer 12 is formed of an insulating body, and aluminum oxide ($Al_2O_3$) fine particles are used as insulating body fine particles, a relatively high electromotive force (Voc) is obtained.

In a case in which the blocking layer 14, like other layers, is formed of a conductor or a semiconductor as well, electron conduction occurs in the blocking layer 14.

In addition, electron conduction occurs even in the electron transport layer 15.

The photoelectric conversion element and the solar cell of the present invention are not limited to the above-described preferred aspects, and the constitutions and the like of the respective aspects can be appropriately combined together within the scope of the gist of the present invention. For example, in the photoelectric conversion element 10C or 10D, like the photoelectric conversion element 10F, it is also possible to provide a constitution in which the hole transport layer 3B is not provided.

In the present invention, materials and the respective members which are used in the photoelectric conversion element and the solar cell can be prepared using ordinary methods except for the light absorber and the compound AC. Regarding photoelectric conversion elements or solar cells in which the perovskite compound is used, it is possible to refer to, for example, ACS Nano, DOI: 10. 1021/nn5036476.

In addition, regarding materials used for dye sensitized solar cells and individual members as well, there are available references. Regarding dye sensitized solar cells, it is possible to refer to, for example, JP2001-291534A, the specification of US4927721A, the specification of US4684537A, the specification of US5084365A, the specification of US5350644A, the specification of US5463057A, the specification of US5525440A, JP1995-249790A (JP-H7-249790A), JP2004-220974A, and JP2008-135197A.

Hereinafter, members and compounds suitable for being used in the photoelectric conversion element and the solar cell of the present invention will be described.

<First electrode 1>

The first electrode 1 includes the conductive support 11 and the photosensitive layer 13 and functions as a working electrode in the photoelectric conversion element 10.

As illustrated in Figs. 1 to 6, the first electrode 1 preferably includes the porous layer 12, the blocking layer 14, and at least one layer of the electron transport layer 15 or the hole transport layer 16.

The first electrode 1 preferably includes at least the blocking layer 14 in terms of short circuit prevention and more preferably includes the porous layer 12 and the blocking layer 14 in terms of light absorption efficiency and short circuit prevention.

In addition, the first electrode 1 preferably includes the electron transport layer 15 or the hole transport layer 16 formed of an organic material since the productivity of the photoelectric conversion element is improved, and the thickness is reduced or the photoelectric conversion element is made to be flexible.

- Conductive support 11 -

The conductive support 11 is not particularly limited as long as the conductive support is conductive and is capable of supporting the photosensitive layer 13 or the like. The conductive support 11 preferably has a constitution in which the conductive support is formed of a conductive material, for example, metal or a constitution in which the glass or plastic support 11a and the transparent electrode 11b formed on the surface of the support 11a as a conductive film are provided. In a case in which the strength of the conductive support 11 is sufficiently maintained, the support 11a is not essentially required.

Among these, the conductive support 11 in which a film of the transparent electrode 11b is formed by applying a conductive metallic oxide onto the surface of the glass or plastic support 11a as illustrated in Figs. 1 to 6 is more preferred. Examples of the support 11 a formed of plastic include transparent polymer films described in Paragraph 0153 of JP2001-291534A. As a material used to form the support 11a, it is possible to use, in addition to glass or plastic, ceramics (JP2005-135902A) or conductive resins (JP2001-160425A). The metallic oxide is preferably a tin oxide (TO) and particularly preferably an indium-tin oxide (a tin-doped indium oxide, ITO) or a fluorine-doped tin oxide such as a fluorine-doped tin oxide (FTO). At this time, the amount of the metallic oxide applied is preferably 0.1 to 100 g per square meter of the surface area of the support 11a. In a case in which the conductive support 11 is used, light preferably enters the conductive support through the support 11a side.

The conductive support 11 is preferably substantially transparent. In the present invention, "being substantially transparent" means that the transmittance of light (having a wavelength of 300 to 1,200 nm) is 10% or higher, preferably 50% or higher, and particularly preferably 80% or higher.

The thicknesses of the support 11a and the conductive support 11 are not particularly limited and are set to appropriate thicknesses. For example, the thicknesses are preferably 0.01 μm to 10 mm, more preferably 0.1 μm to 5 mm, and particularly preferably 0.3 μm to 4 mm.

In a case in which the transparent electrode 11b is provided, the film thickness of the transparent electrode 11b is not particularly limited and is, for example, preferably 0.01 to 30 μm, more preferably 0.03 to 25 μm, and particularly preferably 0.05 to 20 μm.

The conductive support 11 or the support 11a may have a light management function on the surface. For example, the conductive support 11 or the support 11a may have on the surface an antireflection film obtained by alternately laminating high-refractive index films and low-refractive index oxide films which is described in JP2003-123859A or may have a light guide function described in JP2002-260746A.

- Blocking layer 14 -

In the present invention, as in the photoelectric conversion elements 10A to 10C and 10F, the blocking layer 14 is preferably provided on the surface of the transparent electrode 11b, that is, between the conductive support 11 and the porous layer 12, the photosensitive layer 13, the hole transport layer 3, or the like.

In the photoelectric conversion element and the solar cell, for example, in a case in which the photosensitive layer 13 or the hole transport layer 3 and the transparent electrode 11b or the like are electrically connected with each other, reverse currents are generated. The blocking layer 14 performs a function of preventing these reverse currents. The blocking layer 14 is also referred to as a short circuit prevention layer.

The blocking layer 14 can also be made to function as a foundation that supports the light absorber.

The blocking layer 14 may also be provided in a case in which the photoelectric conversion element includes an electron transport layer. For example, in the case of the photoelectric conversion element 10D, the blocking layer may be provided between the conductive support 11 and the electron transport layer 15, and in the case of the photoelectric conversion element 10E, the blocking layer may be provided between the second electrode 2 and the electron transport layer 4.

A material used to form the blocking layer 14 is not particularly limited as long as the material is capable of performing the above-described function, but is preferably a substance which transmits visible light and is insulating with respect to the conductive support 11 (the transparent electrode 11b) and the like. The "substance insulating with respect to the conductive support 11 (the transparent electrode 11b)" specifically refers to a compound having an energy level of the conduction band which is equal to or higher than the energy level of the conduction band of a material used to form the conductive support 11 (a metallic oxide used to form the transparent electrode 11b) and is equal to or lower than the energy level of the conduction band of a material constituting the porous layer 12 or the ground state of the light absorber (n-type semiconductor compound).

Examples of a material used to form the blocking layer 14 include silicon oxide, magnesium oxide, aluminum oxide, calcium carbonate, cesium carbonate, polyvinyl alcohols, polyurethanes, and the like. In addition, the material may be a material that is ordinarily used as a photoelectric conversion material, and examples thereof include titanium oxide, tin oxide, zinc oxide, niobium oxide, tungsten oxide, and the like. Among these, titanium oxide, tin oxide, magnesium

oxide, aluminum oxide, and the like are preferred.

The film thickness of the blocking layer 14 is preferably 0.001 to 10 μm, more preferably 0.005 to 1 μm, and particularly preferably 0.01 to 0.1 μm.

In the present invention, the film thicknesses of the respective layers can be measured by observing cross sections of the photoelectric conversion element 10 using a scanning electron microscope (SEM) or the like.

- Porous layer 12 -

In the present invention, as in the photoelectric conversion elements 10A, 10B, and 10F, the porous layer 12 is preferably provided on the transparent electrode 11b. In a case in which the photoelectric conversion element includes the blocking layer 14, the porous layer 12 is preferably formed on the blocking layer 14.

The porous layer 12 is a layer that functions as a scaffold for carrying the photosensitive layer 13 on the surface. In solar cells, in order to increase the light absorption efficiency, it is preferable to increase the surface area of at least a portion receiving light such as sunlight, and it is more preferable to increase the surface area of the porous layer 12 as a whole.

The porous layer 12 is preferably a fine particle layer having pores which is formed of fine particles of a material used to form the porous layer 12 being accumulated or in close contact with each other. The porous layer 12 may be a fine particle layer formed of two or more kinds of fine particles being accumulated together. In a case in which the porous layer 12 is a fine particle layer having pores, it is possible to increase the amount of the light absorber carried (adsorption amount).

In order to increase the surface area of the porous layer 12, it is preferable to increase the surface area of individual fine particles that constitute the porous layer 12. In the present invention, the surface area of fine particles used to form the porous layer 12 in a state in which the fine particles are applied onto the conductive support 11 and the like is preferably 10 or more times and more preferably 100 or more times the projected area. The upper limit thereof is not particularly limited, but is, generally, approximately 5,000 times. Regarding the particle diameters of the fine particles used to form the porous layer 12, the average particle diameter of the diameters of equivalent circles of the projected areas is preferably 0.001 to 1 μm for the primary particles. In a case in which the porous layer 12 is formed using a dispersion of the fine particles, the average particle diameter of the fine particles is preferably 0.01 to 100 μm in terms of the average particle diameter in the dispersion.

For the material used to form the porous layer 12, there is no particular limitation regarding conductivity, and thus the material may be an insulating body (insulating material), a conductive material, or a semiconductor (semiconductive material).

As the material used to form the porous layer 12, it is possible to use, for example, chalcogenides (for example, oxides, sulfides, selenides, and the like) of metal, compounds having a perovskite-type crystal structure (except for the perovskite compound being used as the light absorber), oxides of silicon (for example, silicon dioxide and zeolite), or carbon nanotubes (including carbon nanowires, carbon nanorods, and the like).

The chalcogenides of metal are not particularly limited, and preferred examples thereof include individual oxides of titanium, tin, zinc, tungsten, zirconium, hafnium, strontium, indium, cerium, yttrium, lanthanum, vanadium, niobium, aluminum, or tantalum, cadmium sulfide, cadmium selenide, and the like. Examples of the crystal structure of the chalcogenides of metal include an anatase-type crystal structure, a brookite-type crystal structure, and a rutile-type crystal structure, and an anatase-type crystal structure and a brookite-type crystal structure are preferred.

The compounds having a perovskite-type crystal structure are not particularly limited, and examples thereof include transition metal oxides and the like. Examples thereof include strontium titanate, calcium titanate, barium titanate, lead titanate, barium zirconate, barium stannate, lead zirconate, strontium zirconate, strontium tantalate, potassium niobate, bismuth ferrate, barium strontium titanate, lanthanum barium titanate, calcium titanate, sodium titanate, and bismuth titanate. Among these, strontium titanate, calcium titanate, and the like are preferred.

The carbon nanotubes have a shape obtained by rolling a carbon film (graphene sheet) in a tubular shape. Carbon nanotubes are classified into single-walled carbon nanotubes (SWCNT) obtained by coiling one graphene sheet in a cylindrical shape, double-walled carbon nanotubes (DWCNT) obtained by coiling two graphene sheets in a concentric shape, and multi-walled carbon nanotubes (MWCNT) obtained by coiling multiple graphene sheets in a concentric shape. As the porous layer 12, any carbon nanotubes can be used without any particular limitation.

Among these, the material used to form the porous layer 12 is preferably an oxide of titanium, tin, zinc, zirconium, aluminum, or silicon or a carbon nanotube and more preferably titanium oxide or aluminum oxide.

The porous layer 12 may be formed of at least one of the chalcogenide of metal, the compound having a perovskite-type crystal structure, the oxide of silicon, or the carbon nanotube or may be formed of a plurality thereof.

The film thickness of the porous layer 12 is not particularly limited and is generally in a range of 0.05 to 100 μm, and, in the case of being used as a solar cell, the film thickness is preferably 0.1 to 50 μm and more preferably 0.2 to 30 μm.

- Electron transport layer 15 -

In the present invention, as in the photoelectric conversion element 10D, the electron transport layer 15 is preferably provided on the surface of the transparent electrode 11b.

The electron transport layer 15 has a function of transporting electrons generated in the photosensitive layer 13 to the conductive support 11. The electron transport layer 15 is formed of an electron-transporting material capable of exhibiting the above-described function. The electron-transporting material is not particularly limited and is preferably an organic material (organic electron-transporting material). Examples of the organic electron-transporting material include fullerene compounds such as [6,6]-phenyl-C61-butyric acid methyl ester ($PC_{61}BM$), perylene compounds such as perylene tetracarboxylic diimide (PTCDI), additionally, low-molecular-weight compounds such as tetracyanoquinodimethane (TCNQ), high-molecular-weight compounds, and the like.

The film thickness of the electron transport layer 15 is not particularly limited and is preferably 0.001 to 10 $\mu$m and more preferably 0.01 to 1 $\mu$m.

- Hole transport layer 16 -

In the present invention, as in the photoelectric conversion element 10E, the hole transport layer 16 is preferably provided on the surface of the transparent electrode 11b.

The hole transport layer 16 is the same as the hole transport layer 3 described below except for the fact that the hole transport layer is formed at a different location.

- Photosensitive layer (light-absorbing layer) 13 -

The photosensitive layer 13 is preferably provided on the surface (also on the inner surfaces of recess portions in a case in which the surface provided with the photosensitive layer 13 is uneven) of each of the porous layer 12 (in the photoelectric conversion elements 10A, 10B, and 10F), the blocking layer 14 (in the photoelectric conversion element 10C), the electron transport layer 15 (in the photoelectric conversion element 10D), and the hole transport layer 16 (in the photoelectric conversion element 10E).

In the present invention, the light absorber needs to contain at least one specific perovskite compound described below and may contain two or more perovskite compounds. In addition, the light absorber may also include a light absorber other than perovskite compounds together with the perovskite compound. Examples of the light absorber other than perovskite compounds include metallic complex dyes and organic dyes. At this time, the ratio between the perovskite compound and the light absorber other than the perovskite compound is not particularly limited.

The photosensitive layer 13 may be a single layer or a laminate of two or more layers. In a case in which the photosensitive layer 13 is a laminate structure of two or more layers, the laminate structure may be a laminate structured formed by laminating layers made of mutually different light absorbers or a laminate structure including an interlayer including a hole-transporting material laminated between the photosensitive layer and the photosensitive layer.

An aspect of the photosensitive layer 13 being present on the conductive support 11 is as described above. The photosensitive layer 13 is preferably provided on the surface of each of the above-described layers so that excited electrons flow into the conductive support 11 or the second electrode 2. At this time, the photosensitive layer 13 may be provided on the entire surface or on a part of the surface of the above-described layers.

The photosensitive layer 13 may have the compound represented by Formula (AC) on the surface thereof. An aspect in which the compound AC is present on the surface is as described above.

The film thickness of the photosensitive layer 13 is appropriately set according to aspects of the photosensitive layer 13 provided on the conductive support 11 and is not particularly limited. For example, the film thickness is preferably 0.001 to 100 $\mu$m, more preferably 0.01 to 10 $\mu$m, and particularly preferably 0.01 to 5 $\mu$m.

In a case in which the porous layer 12 is provided, the total film thickness including the film thickness of the porous layer 12 is preferably 0.01 $\mu$m or more, more preferably 0.05 $\mu$m or more, still more preferably 0.1 $\mu$m or more, and particularly preferably 0.3 $\mu$m or more. In addition, the total film thickness is preferably 100 $\mu$m or less, more preferably 50 $\mu$m or less, and still more preferably 30 $\mu$m or less. The total film thickness can be set in a range obtained by appropriately combining the above-described values. For example, the total film thickness is preferably 0.01 to 100 $\mu$m, more preferably 0.05 to 50 $\mu$m, and particularly preferably 0.1 to 30 $\mu$m.

In the photoelectric conversion element 10, in a case in which the porous layer 12 and the hole transport layer 3 are provided, the total film thickness of the porous layer 12, the photosensitive layer 13, the compound layer 5, and the hole transport layer 3 is not particularly limited, but is preferably, for example, 0.01 to 200 $\mu$m, more preferably 0.05 to 50 $\mu$m, and still more preferably 0.1 to 30 $\mu$m.

In the present invention, in a case in which the photosensitive layer is provided in a thick film shape (the photosensitive layers 13B and 13C), the light absorber included in the photosensitive layer also functions as a hole-transporting material.

The amount of the perovskite compound used is preferably an amount at which at least some of the surface of the first electrode 1 is covered and more preferably an amount at which the surface is fully covered.

[Light absorber in photosensitive layer]

The photosensitive layer 13 includes, as a light absorber, a perovskite compound having "an element belonging to Group I of the periodic table or a cationic organic group A", "a metallic atom M other than elements belonging to Group I of the periodic table", and "an anionic atom or atomic group X".

The element belonging to Group I of the periodic table or the cationic organic group A, the metallic atom M, and the anionic atom or atomic group X in the perovskite compound are present as individual constituent ions of cations (in some cases, referred to as cations A for convenience), metallic cations (in some cases, referred to as cations M for convenience), and anions (in some cases, referred to as anions X for convenience) respectively in the perovskite-type crystal structure.

In the present invention, the cationic organic group refers to an organic group having a property of turning into a cation in the perovskite-type crystal structure, and the anionic atom or atomic group refers to an atom or atomic group having a property of turning into an anion in the perovskite-type crystal structure.

In the perovskite compound being used in the present invention, the cation A is an organic cation made of a cation of an element belonging to Group I of the periodic table or a cationic organic group A. The cation A is preferably an organic cation.

The cation of an element belonging to Group I of the periodic table is not particularly limited, examples thereof include cations ($Li^+$, $Na^+$, $K^+$, and $Cs^+$) of individual elements of lithium (Li), sodium (Na), potassium (K), and cesium (Cs), and a cation of cesium ($Cs^+$) is particularly preferred.

The organic cation is not particularly limited as long as the organic cation is a cation of an organic group having the above-described property, but is more preferably an organic cation of a cationic organic group represented by Formula (1).

Formula (1): $R^{1a}\text{-}NH_3$

In the formula, $R^{1a}$ represents a substituent. $R^{1a}$ is not particularly limited as long as $R^{1a}$ is an organic group, but is preferably an alkyl group, a cycloalkyl group, an alkenyl group, an alkynyl group, an aryl group, a heteroaryl group, or a group that can be represented by Formula (2). Among these, an alkyl group and the group that can be represented by Formula (2) are more preferred.

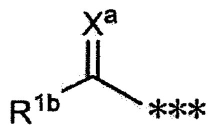

Formula (2)

In the formula, $X^a$ represents $NR^{1c}$, an oxygen atom, or a sulfur atom. $R^{1b}$ and $R^{1c}$ each independently represent a hydrogen atom or a substituent. *** represents a bond with the nitrogen atom in Formula (1).

In the present invention, the organic cation of the cationic organic group A is preferably an organic ammonium cation ($R^{1a}\text{-}NH_3^+$) made of an ammonium cationic organic group A formed by bonding $R^{1a}$ and $NH_3$ in Formula (1). In a case in which this organic ammonium cation is capable of employing a resonance structure, the organic cation includes a cation having a resonance structure in addition to the organic ammonium cation. For example, in a case in which $X^a$ is NH ($R^{1c}$ is a hydrogen atom) in the group that can be represented by Formula (2), the organic cation also includes an organic amidinium cation which is one of the resonance structures of the organic ammonium cation in addition to an organic ammonium cation of an ammonium cationic organic group formed by bonding the group that can be represented by Formula (2) and $NH_3$. Examples of the organic amidinium cation made of an amidinium cationic organic group include cations represented by Formula ($A^{am}$). In the present specification, there are cases in which the cations represented by Formula ($A^{am}$) will be referred to as "$R^{1b}C(=NH)\text{-}NH_3$" for convenience.

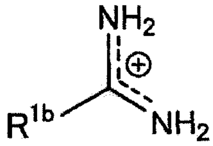

Formula ($A^{am}$)

The alkyl group is preferably an alkyl group having 1 to 18 carbon atoms, more preferably an alkyl group having 1 to 6 carbon atoms, and still more preferably an alkyl group having 1 to 3 carbon atoms. Examples thereof include methyl, ethyl, propyl, isopropyl, butyl, tert-butyl, pentyl, hexyl, and the like.

The cycloalkyl group is preferably a cycloalkyl group having 3 to 8 carbon atoms, and examples thereof include cyclopropyl, cyclopentyl, cyclohexyl, and the like.

The alkenyl group is preferably an alkenyl group having 2 to 18 carbon atoms and more preferably an alkenyl group having 2 to 6 carbon atoms. Examples thereof include vinyl, allyl, butenyl, hexenyl, and the like.

The alkynyl group is preferably an alkynyl group having 2 to 18 carbon atoms and more preferably an alkynyl group having 2 to 4 carbon atoms, and examples thereof include ethynyl, butynyl, hexynyl, and the like.

The aryl group is preferably an aryl group having 6 to 14 carbon atoms and more preferably, for example, an aryl group having 6 to 12 carbon atoms, and examples thereof include phenyl.

Examples of the heteroaryl group include groups formed of an aromatic hetero ring alone and groups formed of a condensed hetero ring obtained by condensing another ring, for example, an aromatic ring, an aliphatic ring, or a hetero ring with the aromatic hetero ring.

The ring-constituting hetero atom constituting the aromatic hetero ring is preferably a nitrogen atom, an oxygen atom, or a sulfur atom. In addition, regarding the number of ring members of the aromatic hetero ring, three- to eight-membered rings are preferred, and five-membered rings or six-membered rings are more preferred.

Examples of the five-membered aromatic hetero ring and the condensed hetero ring including the five-membered aromatic hetero ring include individual cyclic groups such as a pyrrole ring, an imidazole ring, a pyrazole ring, an oxazole ring, a thiazole ring, a triazole ring, a furan ring, a thiophene ring, a benzimidazole ring, a benzoxazole ring, a benzothiazole ring, an indoline ring, and an indazole ring. In addition, examples of the six-membered aromatic hetero ring and the condensed hetero ring including the six-membered aromatic hetero ring include individual cyclic groups such as a pyridine ring, a pyrimidine ring, a pyrazine ring, a triazine ring, a quinoline ring, and a quinazoline ring.

In the group that can be represented by Formula (2), $X^a$ represents $NR^{1c}$, an oxygen atom, or a sulfur atom and is preferably $NR^{1c}$. Here, $R^{1c}$ represents a hydrogen atom or substituent and is preferably a hydrogen atom, an alkyl group, a cycloalkyl group, an alkenyl group, an alkynyl group, an aryl group, or a heteroaryl group and more preferably a hydrogen atom.

$R^{1b}$ represents a hydrogen atom or a substituent and is preferably a hydrogen atom. Examples of a substituent that can be employed by $R^{1b}$ include an amino group, an alkyl group, a cycloalkyl group, an alkenyl group, an alkynyl group, an aryl group, and a heteroaryl group.

An alkyl group, a cycloalkyl group, an alkenyl group, an alkynyl group, an aryl group, and a heteroaryl group that can be respectively employed by $R^{1b}$ and $R^{1c}$ are the same as the respective groups as $R^{1a}$, and preferred groups are also identical thereto.

Examples of the group that can be represented by Formula (2) include a (thio)acyl group, a (thio)carbamoyl group, an imidoyl group, and an amidino group.

Examples of the (thio)acyl group include an acyl group and a thioacyl group. The acyl group is preferably an acyl group having a total of 1 to 7 carbon atoms, and examples thereof include formyl, acetyl ($CH_3C(=O)-$), propionyl, hexanoyl, and the like. The thioacyl group is preferably a thioacyl group having a total of 1 to 7 carbon atoms, and examples thereof include thioformyl, thioacetyl ($CH_3C(=S)-$), thiopropionyl, and the like.

Examples of the (thio)carbamoyl group include a carbamoyl group ($H_2NC(=O)-$) and thiocarbamoyl group ($H_2NC(=S)-$).

The imidoyl group is a group represented by $R^{1b}-C(=NR^{1c})-$, $R^{1b}$ and $R^{1c}$ each are preferably a hydrogen atom or an alkyl group, and the alkyl group is more preferably the same as the alkyl group as $R^{1a}$. Examples thereof include formimidoyl ($HC(=NH)-$), acetoimidoyl ($CH_3C(=NH)-$), propionimidoyl ($CH_3CH_2C(=NH)-$), and the like. Among these, formimidoyl is preferred.

The amidino group as the group that can be represented by Formula (2) has a structure in which $R^{1b}$ of the imidoyl group is an amino group and $R^{1c}$ is a hydrogen atom ($-C(=NH)NH_2$).

All of the alkyl group, the cycloalkyl group, the alkenyl group, the alkynyl group, the aryl group, the heteroaryl group, and the group that can be represented by Formula (2) which can be employed as $R^{1a}$ may have a substituent. The substituent that $R^{1a}$ may have is not particularly limited, and examples thereof include an alkyl group, a cycloalkyl

group, an alkenyl group, an alkynyl group, an aryl group, a heterocyclic group, an alkoxy group, an alkylthio group, an amino group, an alkylamino group, an arylamino group, an acyl group, an alkylcarbonyloxy group, an aryloxy group, an alkoxycarbonyl group, an aryloxycarbonyl group, an acylamino group, a sulfonamide group, a carbamoyl group, a sulfamoyl group, a halogen atom, a cyano group, a hydroxyl group, and a carboxyl group. The respective substituents that $R^{1a}$ may have may be further substituted with another substituent.

In the perovskite compound being used in the present invention, the metallic cation M is not particularly limited as long as the metallic cation is a cation of the metallic atom M other than elements belonging to Group I of the periodic table and a cation of a metallic atom capable of employing a perovskite-type crystal structure. Examples of the metallic atom include metallic atoms such as calcium (Ca), strontium (Sr), cadmium (Cd), copper (Cu), nickel (Ni), manganese (Mn), iron (Fe), cobalt (Co), palladium (Pd), germanium (Ge), tin (Sn), lead (Pb), ytterbium (Yb), europium (Eu), indium (In), titanium (Ti), and bismuth (Bi). Among these, the metallic atom M is preferably a divalent cation, more preferably at least one selected from the group consisting of a divalent lead cation ($Pb^{2+}$), a divalent copper cation ($Cu^{2+}$), a divalent germanium cation ($Ge^{2+}$), and a divalent tin cation ($Sn^{2+}$), still more preferably $Pb^{2+}$ or $Sn^{2+}$, and particularly preferably $Pb^{2+}$. M may represent one metallic atom or two or more metallic atoms. In a case in which M represents two or more metallic atoms, a Pb atom and a Sn atom are preferred. The fraction of the metallic atom at this time is not particularly limited.

In the perovskite compound being used in the present invention, the anion X represents an anion of an anionic atom or atomic group X. Preferred examples of the anion include anions of halogen atoms and anions of individual atomic groups such as $NCS^-$, $NCO^-$, $HO^-$, $NO_3^-$, $CH_3COO^-$, and $HCOO^-$. Among these, anions of halogen atoms are preferred. Examples of the halogen atoms include a fluorine atom, a chlorine atom, a bromine atom, an iodine atom, and the like.

The anion X may represent an anion of one anionic atom or atomic group or anions of two or more anionic atoms or atomic groups. In a case in which the anion X represents an anion of one anionic atom or atomic group, an anion of an iodine atom is preferred. Meanwhile, in a case in which the anion X represents anions of two or more anionic atoms or atomic groups, anions of two halogen atoms, particularly, an anion of a chlorine atom and an anion of an iodine atom are preferred. The fractions of two or more anions are not particularly limited.

The perovskite compound that is used in the present invention is preferably a perovskite compound which has a perovskite-type crystal structure having the respective constituent ions described above and is represented by Formula (I).

Formula (I): $A_aM_mX_x$

In the formula, A represents an element in Group I of the periodic table or a cationic organic group. M represents a metallic atom that is not an element in Group I of the periodic table. X represents an anionic atom or atomic group.

a represents 1 or 2, m represents 1, and a, m, and x satisfy $a+2m=x$.

In Formula (I), the element belonging to Group I of the periodic table or the cationic organic group A forms the cation A in the perovskite-type crystal structure. Therefore, the element belonging to Group I of the periodic table and the cationic organic group A are not particularly limited as long as the element and the cationic organic group are an element or a group which turns into the cation A and is capable of constituting the perovskite-type crystal structure. The element belonging to Group I of the periodic table or the cationic organic group A is the same as the element belonging to Group I of the periodic table or the cationic organic group A described in the section of the cation A, and a preferred range thereof is also identical.

The metallic atom M is a metallic atom forming the metallic cation M in the perovskite-type crystal structure. Therefore, the metallic atom M is not particularly limited as long as the metallic atom is an atom other than elements belonging to Group I of the periodic table, turns into the metallic cation M, and is capable of constituting the perovskite-type crystal structure. The metallic atom M is the same as the metallic atom described in the section of the metallic cation M, and a preferred range thereof is also identical.

The anionic atom or atomic group X forms the anion X in the perovskite-type crystal structure. Therefore, the anionic atom or atomic group X is not particularly limited as long as the anionic atom or atomic group is an atom or atomic group which turns into the anion X and is capable of constituting the perovskite-type crystal structure. The anionic atom or atomic group X is the same as the anionic atom or atomic group described in the section of the anion X, and a preferred range thereof is also identical.

In a case in which a is 1, the perovskite compound represented by Formula (I) is a perovskite compound represented by Formula (I-1), and, in a case in which a is 2, the perovskite compound represented by Formula (I) is a perovskite compound represented by Formula (1-2).

Formula (I-1): $AMX_3$

Formula (1-2): $A_2MX_4$

In Formula (1-1) and Formula (1-2), A represents an element belonging to Group I of the periodic table or a cationic organic group and is the same as A in Formula (I), and a preferred range thereof is also identical.

M represents a metallic atom other than elements belonging to Group I of the periodic table and is the same as M in Formula (I), and a preferred range thereof is also identical.

X represents an anionic atom or atomic group and is the same as X in Formula (I), and a preferred range thereof is also identical.

The perovskite compound being used in the present invention may be any one of the compound represented by Formula (1-1) and the compound represented by Formula (1-2) or a mixture thereof. Therefore, in the present invention, it is not necessary to clearly and strictly differentiate compounds depending on compositional formulae, molecular formulae, crystal structures, and the like as long as at least one perovskite compound is present as the light absorber.

Hereinafter, specific examples of the perovskite compound that can be used in the present invention will be described, but the present invention is not limited thereto. In the following description, the compound represented by Formula (1-1) and the compound represented by Formula (1-2) will be differentiated from each other. However, there are cases in which, depending on synthesis conditions and the like, even compounds exemplified as the compound represented by Formula (1-1) turn into the compound represented by Formula (1-2) or mixtures of the compound represented by Formula (1-1) and the compound represented by Formula (1-2). Similarly, there are cases in which even compounds exemplified as the compound represented by Formula (1-2) turn into the compound represented by Formula (1-1) or mixtures of the compound represented by Formula (I-1) and the compound represented by Formula (1-2).

Specific examples of the compound represented by Formula (1-1) include $CH_3NH_3PbCl_3$, $CH_3NH_3PbBr_3$, $CH_3NH_3PbI_3$, $CH_3NH_3PbBrI_2$, $CH_3NH_3PbBr_2I$, $CH_3NH_3SnBr_3$, $CH_3NH_3SnI_3$, $CH_3NH_3GeCl_3$, $CH(=NH)NH_3PbI_3$, and $CsSnI_3CsGeI_3$.

Specific examples of the compound represented by Formula (1-2) include $(C_2H_5NH_3)_2PbI_4$, $(C_{10}H_{21}NH_3)_2PbI_4$, $(CH_2=CHNH_3)_2PbI_4$, $(CH\equiv CNH_3)_2PbI_4$, $(n\text{-}C_3H_7NH_3)_2PbI_4$, $(n\text{-}C_4H_9NH_3)_2PbI_4$, $(C_6H_5NH_3)_2PbI_4$, $(C_6H_5CH_2CH_2NH_3)_2PbI_4$, $(C_6H_3F_2NH_3)_2PbI_4$, $(C_6F_5NH_3)_2PbI_4$, $(C_4H_3SNH_3)_2PbI_4$, $(CH_3NH_3)_2CuCl_4$, $(C_4H_9NH_3)_2GeI_4$, and $(C_3H_7NH_3)_2FeBr_4$. Here, $C_4H_3SNH_3$ in $(C_4H_3SNH_3)_2PbI_4$ is aminothiophene.

The perovskite compound can be synthesized from a compound represented by Formula (II) and a compound represented by Formula (III).

Formula (II): AX

Formula (III): $MX_2$

In Formula (II), A represents an element belonging to Group I of the periodic table or a cationic organic group and is the same as A in Formula (I), and a preferred range thereof is also identical. In Formula (II), X represents an anionic atom or atomic group and is the same as X in Formula (I), and a preferred range thereof is also identical.

In Formula (III), M represents a metallic atom other than elements belonging to Group I of the periodic table and is the same as M in Formula (I), and a preferred range thereof is also identical. In Formula (III), X represents an anionic atom or atomic group and is the same as X in Formula (I), and a preferred range thereof is also identical.

Examples of the method for synthesizing the perovskite compound include the method described in ACS Nano, DOI: 10. 1021/nn5036476. Additionally, examples thereof also include the method described in Akihiro Kojima, Kenjiro Teshima, Yasuo Shirai, and Tsutomu Miyasaka, "Organometal Halide Perovskites as Visible-Light Sensitizers for Photovoltaic Cells", J.Am. Chem. Soc., 2009, 131 (17), pp. 6,050 and 6,051.

The amount of the light absorber used needs to be an amount at which at least some of the surface of the first electrode 1 is covered and is preferably an amount at which the surface is fully covered.

The content of the perovskite compound in the photosensitive layer 13 is generally 1 to 100% by mass.

- Compound layer 5 -

In the present invention, the compound represented by Formula (AC) is present on the surface of the first electrode. The aspect and state of "having the compound AC on the surface of the first electrode" are as described above. In the photoelectric conversion element of the present invention, the hole transport layer 3 or the electron transport layer 4 is preferably provided on the first electrode 1. In this case, the compound layer 5 is interposed between the surface of the first electrode 1 and the layer provided on the first electrode 1.

The compound AC may be present on the surface of the first electrode. Whether or not the compound AC is present on the surface of the first electrode can be checked in the following manner. That is, the surface of the first electrode having a sufficient area is washed with an organic solvent capable of dissolving the compound AC or water.

A filtrate obtained by filtering the obtained wash solution is condensed and purified as necessary and is analyzed by means of gel permeation chromatography (GPC), high-performance liquid chromatography (HPLC), or individual nuclear magnetic resonances (NMR). In the above-described manner, the presence or absence of the compound AC on the surface of the first electrode is checked, and it is possible to determine the amount of the compound present.

The amount of the compound AC present on the surface is not particularly limited as long as the effects of the present invention are exhibited. For example, the amount of the compound present needs to be an amount at which the compound can be provided on the first electrode by bringing a liquid including the compound AC into contact with the surface, preferably, the full surface of the first electrode. At this time, the amount of the compound present can be changed depending on the concentration of the liquid including the compound AC, the surface area which the liquid is brought into contact with, and the like. The amount of the compound AC present is not fixed and, for example, 0.1 $mg/m^2$ to 100 $g/m^2$ or, furthermore, 1 $mg/m^2$ to 1 $g/m^2$.

In the present invention, it is preferable to uniformly cover the surface of the first electrode with the compound AC from the viewpoint of preventing back charge transfer.

In a case in which the compound AC is provided on the surface of the first electrode, the photoelectric conversion element or the solar cell is excellent in terms of durability. The details thereof are not yet clear, but are assumed as described below. That is, in a case in which the compound AC is provided on the surface of the first electrode, it is possible to enhance compatibility, interactions, and the like between the first electrode and a layer formed on the first electrode (the hole transport layer, the electron transport layer, the second electrode, or the like). Particularly, hetero rings having at least one of a sulfur atom or an oxygen atom as a ring-constituting atom exhibit excellent characteristics with respect to, for example, pyridine since the hetero rings have a small influence on the breakage or deformation of the crystal structure of perovskite or is hydrophobic and are capable of effectively suppressing back electron transfer from the first electrode to the layer provided on the first electrode (the photoelectric conversion elements 10A to 10D and 10F) or back hole transfer from the layer provided on the first electrode to the first electrode (the photoelectric conversion element 10E). In addition, the hetero rings inherently do not prevent charge transfer which is originally required for the surface (interface) of the first electrode. Therefore, the adhesiveness between the first electrode and the layer formed on the first electrode enhances, charge transfer (electron transfer) rapidly occurs in a predetermined direction, or abnormalities in layer interfaces or deterioration due to moisture absorption (the decomposition of the perovskite compound) can be prevented. Therefore, it is considered that a decrease in currents is suppressed even after time has elapsed and, furthermore, a decrease in the photoelectric conversion efficiency can also be suppressed.

It is considered that, in a case in which the compound AC has a halogen atom or a hydrophobic group such as an alkyl group having 5 or more carbon atoms or a group having a halogen atom as a substituent $R^{AC}$, the above-described effect further enhances.

On the surface of the first electrode, at least one kind of compound AC needs to be present, and a plurality of kinds of compounds may be present.

The compound AC is the compound represented by Formula (AC).

Formula (AC)

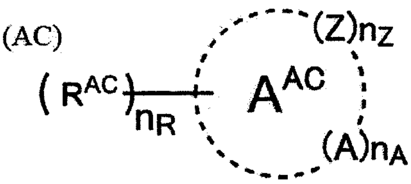

In the formula, a ring $A^{AC}$ represents a hetero ring. Z represents a sulfur atom or an oxygen atom. $n_z$ represents an integer of 1 or more. A represents >C=C$R^{Y1}R^{Y2}$, >C=S, >C=O, or >C=N$R^{Y3}$. $R^{Y1}$ and $R^{Y2}$ each independently represent a substituent. $R^{Y3}$ represents a hydrogen atom or substituent. $n_A$ represents an integer of 0 or more. $R^{AC}$ represents a substituent. $n_R$ represents an integer of 0 or more. Here, when Z is a sulfur atom, and $n_z$ is 1, $n_R$ represents an integer of 1 or more.

Z is a ring-constituting atom constituting the ring $A^{AC}$ and preferably an oxygen atom.

$n_z$ represents an integer of 1 or more and is preferably 1 to 6, more preferably 1 or 2, and still more preferably 1.

In a case in which $n_z$ is an integer of 2 or more, a plurality of Z's may be identical to or different from each other, and at least one of them is preferably an oxygen atom.

A is a group in which ">C=" in A is used as a ring-constituting atom of the ring $A^{AC}$, two single bonds of the carbon atoms are respectively bonded to the ring-constituting atom of the ring $A^{AC}$, and the carbon atoms are combined into the ring $A^{AC}$.

A specifically represents >C=C$R^{Y1}R^{Y2}$, >C=S, >C=O, or >C=N$R^{Y3}$. Here, $R^{Y1}$ and $R^{Y2}$ each independently represent a substituent. In addition, $R^{Y3}$ represents a hydrogen atom or substituent. The substituent that can be employed as $R^{Y1}$ to $R^{Y3}$ is not particularly limited, and examples thereof include the substituent that $R^{1a}$ in Formula (I) may have.

$R^{Y1}$ and $R^{Y2}$ may be bonded to each other and form a ring. Rings formed of $R^{Y1}$ and $R^{Y2}$ are not particularly limited and may be the same ring as the ring $A^{AC}$.

$n_A$ represents an integer of 0 or more and, in some cases, employs an integer of 1 or more depending on the aspect of the ring $A^{AC}$ (for example, the presence and absence of aromaticity). $n_A$ preferably represents an integer of 0 to 3 and is more preferably 0 or 1 and still more preferably 0.

The ring $A^{AC}$ includes a carbon atom and Z as ring-constituting atoms and, in a case in which $n_A$ is an integer of 1 or more, includes the carbon atom (>C=) in A.

The number of members in the ring $A^{AC}$ is not particularly limited, and the ring $A^{AC}$ is preferably a three- to eight-membered ring and more preferably a five-membered ring or a six-membered ring.

Examples of the ring $A^{AC}$ include aromatic hetero rings and aliphatic hetero rings, and aromatic hetero rings are preferred.

The aromatic hetero rings refer to hetero rings exhibiting aromaticity. The aliphatic hetero rings refer to hetero rings other than the aromatic hetero rings, and examples thereof include saturated aliphatic hetero rings and saturated aliphatic hetero rings not exhibiting aromaticity.

Examples of the aromatic hetero rings include a thiophene ring and a furan ring.

Examples of the saturated aliphatic hetero rings include an oxetane ring, a tetrahydrofuran ring, a tetrahydropyran ring, a dioxolane ring, a dioxane ring, a trimethylene sulfide ring, a tetrahydrothiophene ring, a pentamethylene sulfide ring (tetrahydrothiopyran ring), a dithiolane ring, and the like.

Examples of the saturated aliphatic hetero rings include a dihydrofuran ring, a dihydropyran ring, a dihydrothiophene ring, a dihydrothiopyran ring, a thiopyran ring, a dithiol (dithiacyclopentene), and the like.

In the present invention, in a case in which $R^{AC}$'s described below are bonded to each other and form a ring, the ring formed by $R^{AC}$'s and the ring $A^{AC}$ form a fused ring. The above-described fused ring has a variety of structures depending on the kind of $R^{AC}$ and the number of rings formed by $R^{AC}$'s. Examples thereof include a benzothiophene ring, a dibenzothiophene ring, a benzodithiophene ring, a thienothiophene ring, a benzofuran ring, a dibenzofuran ring, a dihydrobenzofuran ring, and the like.

The ring $A^{AC}$ is preferably a five-membered or six-membered aromatic hetero ring, more preferably a five-membered aromatic hetero ring, still more preferably a thiophene ring or a furan ring, and particularly preferably a furan ring.

$R^{AC}$ represents a substituent. The substituent that can be employed as $R^{AC}$ is not particularly limited, and examples thereof include the substituent that $R^{1a}$ in Formula (I) may have.

The substituent that can be employed as $R^{AC}$, for example, an alkyl group, an alkenyl group, an alkynyl group, an aryl group, a heterocyclic group, an alkoxy group, or an alkylthio group further includes a group including the substituent that $R^{1a}$ may have as a substituent. Examples of the above-described group include groups in which a hydrogen atom of each group of an alkyl group, an alkenyl group, an alkynyl group, an aryl group, a heterocyclic group, an alkoxy group, or an alkylthio group is substituted with a halogen atom (referred to as groups having a halogen atom), groups in which a hydrogen atom of an aryl group or a heterocyclic group is substituted with an alkyl group, and the like.

Among these, the substituent that can be employed as $R^{AC}$ is preferably an alkyl group, an alkenyl group, an alkynyl group, an aryl group, a heterocyclic group, an alkoxy group, an alkylthio group, a halogen atom, or a group having a halogen atom, more preferably an alkyl group, a halogen atom, or a group having a halogen atom, and still more preferably an alkyl group having 5 or more carbon atoms, a halogen atom, or a group having a halogen atom.

The alkyl group is preferably an alkyl group having 1 to 30 carbon atoms, more preferably an alkyl group having 5 to 18 carbon atoms, and still more preferably an alkyl group having 5 to 12 carbon atoms. This alkyl group may be a linear chain or a branched chain. Examples of the alkyl group include methyl, ethyl, linear or branched propyl, linear or branched butyl, linear or branched pentyl, linear or branched hexyl, linear or branched decyl, linear or branched dodecyl, and linear or branched octadecyl.

The alkenyl group, the alkynyl group, the aryl group, the heterocyclic group (heteroaryl group), the alkoxy group, and the alkylthio group are respectively the same as the alkenyl group, the alkynyl group, the aryl group, the heterocyclic group (heteroaryl group), the alkoxy group, and the alkylthio group as $R^{1a}$. In a case in which the heterocyclic group is an aliphatic hetero ring, the aliphatic hetero ring is the same as the aliphatic hetero ring of the ring $A^{AC}$.

Examples of the halogen atom include a fluorine atom, a chlorine atom, a bromine atom, and an iodine atom, and a fluorine atom, a chlorine atom, and a bromine atom are preferred.

In the group having the halogen atom, the number of the halogen atoms substituting the hydrogen atoms is not particularly limited as long as the number is at least one. Groups in which all of the hydrogen atoms are substituted with halogen atoms are preferred. The halogen atoms substituting hydrogen atoms are not particularly limited, examples thereof include a fluorine atom, a chlorine atom, a bromine atom, and an iodine atom, and a fluorine atom is preferred.

The group having the halogen atom is preferably a group in which a hydrogen atom in an alkyl group is substituted with a halogen atom (halogenated alkyl group) and more preferably a group having a fluorine atom as a substituent (fluorinated alkyl group). The fluorinated alkyl group is preferably, for example, trifluoromethyl, trifluoroethyl, heptafluoropropyl, heptafluoroisopropyl, pentadecafluoroheptyl, tridecafluoroheptyl, or the like. The number of carbon atoms in the halogenated alkyl group is not particularly limited, but is preferably 1 to 30, more preferably 1 to 10, and still more preferably 1. The halogenated alkyl group is preferably a perfluoroalkyl group in which all of the hydrogen atoms are substituted with fluorine atoms.

In a case in which $n_R$ is an integer of 2 or more, a plurality of $R^{AC}$'s may be identical to or different from each other. In addition, two adjacent $R^{AC}$'s may be bonded to each other and form a ring.

The substitution location of the ring $A^{AC}$ in $R^{AC}$ is not particularly limited, but is preferably a ring-constituting atom adjacent to Z.

$n_R$ represents an integer of 0 or more and is preferably an integer of 0 to 7, more preferably an integer of 0 to 4, and still more preferably 1 or 2. Here, when Z is a sulfur atom, and $n_z$ is 1, $n_R$ represents an integer of 1 or more and is preferably an integer of 1 to 7, more preferably an integer of 1 to 4, and still more preferably 1 or 2.

The compound AC can also be synthesized according to an ordinary method, and it is also possible to use commercially available products.

Hereinafter, specific examples of the compound AC will be illustrated, but the present invention is not limited thereto.

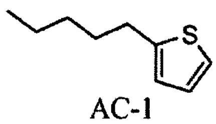
AC-1

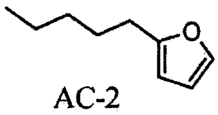
AC-2

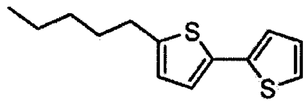
AC-3

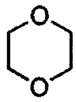
AC-4

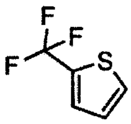
AC-5

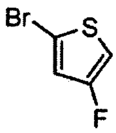
AC-6

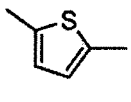
AC-7

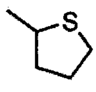
AC-8

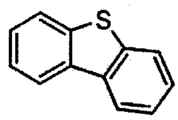
AC-9

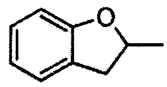
AC-10

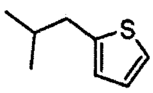
AC-11

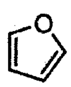
AC-12

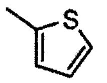
AC-13

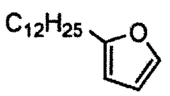
AC-14

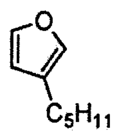
AC-15

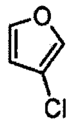
AC-16

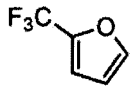
AC-17

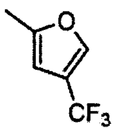
AC-18

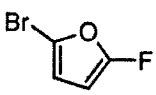
AC-19

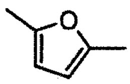
AC-20

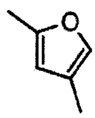
AC-21

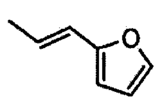
AC-22

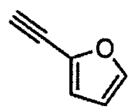
AC-23

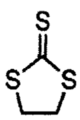
AC-24

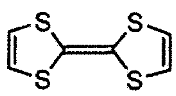
AC-25

<Hole transport layer 3>

The photoelectric conversion element of the present invention is one of preferred aspects in which the hole transport layer 3 is provided between the first electrode and the second electrode as in the photoelectric conversion elements 10A to 10D. In a case in which the compound layer 5 and the hole transport layer 3 are in contact with each other (laminated together), the above-described action of the compound AC can be effectively obtained.

The hole transport layer 3 has a function of supplementing electrons to oxidants of the light absorber and is

preferably a solid-form layer. The hole transport layer 3 is preferably provided between the photosensitive layer 13 in the first electrode 1 and the second electrode 2.

A hole-transporting material that forms the hole transport layer 3 is not particularly limited, and examples thereof include inorganic materials such as CuI and CuNCS, organic hole-transporting materials described in Paragraphs 0209 to 0212 of JP2001-291534A, and the like. Preferred examples of the organic hole-transporting material include conductive polymers such as polythiophene, polyaniline, polypyrrole, and polysilane, spiro compounds in which two rings share a central atom having a tetrahedral structure such as C or Si, aromatic amine compounds such as triarylamine, triphenylene compounds, nitrogen-containing heterocyclic compounds, and liquid-crystalline cyano compounds.

The hole-transporting material is preferably an organic hole-transporting material which can be applied in a solution and turns into solid, and examples thereof include 2,2',7,7'-tetrakis-(N,N-di-p-methoxyphenylamine)-9,9-spirobifluorene (also referred to as Spiro-OMeTAD), poly(3-hexylthiophene-2,5-diyl), 4-(diethylamino)benzoaldehyde, diphenylhydrazone, polyethylene dioxythiophene (PEDOT), and the like.

The film thickness of the hole transport layer 3 is not particularly limited, but is preferably 50 μm or less, more preferably 1 nm to 10 μm, still more preferably 5 nm to 5 μm, and particularly preferably 10 nm to 1 μm.

<Electron transport layer 4>

The photoelectric conversion element of the present invention is one of preferred aspects in which the electron transport layer 4 is provided between the first electrode 1 and the second electrode 2 as in the photoelectric conversion element 10E. Even in this aspect, in a case in which the compound layer 5 and the electron transport layer 4 are in contact with each other (laminated together), the above-described action of the compound AC can be effectively obtained.

The electron transport layer 4 is the same as the electron transport layer 15 except for the fact that electrons are transferred to the second electrode and the electron transport layer is formed at a different location.

<Second electrode 2>

The second electrode 2 functions as a positive electrode or negative electrode in solar cells. The second electrode 2 is not particularly limited as long as the second electrode is conductive and, generally, can be provided with the same constitution as that of the conductive support 11. In a case in which a sufficient strength is maintained, the support 11a is not essentially required.

The structure of the second electrode 2 is preferably a structure having a strong power-collection effect. In order to allow light to reach the photosensitive layer 13, at least one of the conductive support 11 or the second electrode 2 needs to be substantially transparent. In the solar cell of the present invention, it is preferable that the conductive support 11 is transparent and sunlight enters the solar cell through the support 11a side. In this case, the second electrode 2 more preferably has a property of reflecting light.

Examples a material used to form the second electrode 2 include metal such as platinum (Pt), gold (Au), nickel (Ni), copper (Cu), silver (Ag), indium (In), ruthenium (Ru), palladium (Pd), rhodium (Rh), iridium (Ir), osmium (Os), and aluminum (Al), the above-described conductive metallic oxides, carbon materials, conductive polymers, and the like. The carbon materials need to be conductive materials formed of carbon atoms bonded together, and examples thereof include fullerene, carbon nanotubes, graphite, graphene, and the like.

The second electrode 2 is preferably a thin film (including a thin film obtained by means of vapor deposition) of metal or a conductive metallic oxide or a glass or plastic substrate having this thin film. The glass or plastic substrate is preferably a glass substrate having a gold or platinum thin film or a glass substrate on which platinum is vapor-deposited.

The film thickness of the second electrode 2 is not particularly limited, but is preferably 0.01 to 100 μm, more preferably 0.01 to 10 μm, and particularly preferably 0.01 to 1 μm.

<Other constitutions>

In the present invention, in order to prevent the first electrode 1 and the second electrode 2 from coming into contact with each other, a spacer or a separator can also be used instead of the blocking layer 14 and the like or together with the blocking layer 14 and the like.

In addition, a hole-blocking layer may be provided between the second electrode 2 and the hole transport layer 3.

«Solar cell»

The solar cell of the present invention is constituted using the photoelectric conversion element of the present invention. For example, as illustrated in Figs. 1 to 6, the photoelectric conversion element 10 constituted by providing the external circuit 6 can be used as a solar cell. As the external circuit which comes into contact with the first electrode

1 (the conductive support 11) and the second electrode 2, a well-known circuit can be used without any particular limitation.

In order to prevent the deterioration, evaporation, and the like of constituent substances, the solar cell of the present invention preferably has a side surface that is sealed with a polymer, an adhesive, or the like.

As described above, the photoelectric conversion element and the solar cell of the present invention include the first electrode having the compound represented by Formula (AC) on the surface and exhibit excellent durability.

«Method for manufacturing photoelectric conversion element and solar cell»

The photoelectric conversion element and the solar cell of the present invention can be manufactured using a well-known manufacturing method, for example, the methods described in ACS Nano, DOI: 10. 1021/nn5036476.

Hereinafter, a method for manufacturing a photoelectric conversion element and a solar cell of the present invention will be briefly described.

The method for manufacturing a photoelectric conversion element and a solar cell of the present invention (hereinafter, referred to as the manufacturing method of the present invention) is not particularly limited in terms of other steps and the like as long as the manufacturing method includes a step of bringing the first electrode having the photosensitive layer including the perovskite compound represented by Formula (1) as the light absorber into contact with a liquid containing the compound represented by Formula (AC).

In the manufacturing method of the present invention, first, the blocking layer 14, the porous layer 12, and at least one of the electron transport layer 15 or the hole transport layer 16 are formed on the surface of the conductive support 11 as desired.

The blocking layer 14 can be formed by, for example, applying a dispersion including the above-described insulating substance, a precursor compound thereof, or the like onto the surface of the conductive support 11 and firing the dispersion or thermally decomposing the dispersion by means of spraying.

A material used to form the porous layer 12 is preferably used in a fine particle form and more preferably used in a form of fine particles in a dispersion.

A method for forming the porous layer 12 is not particularly limited, and examples thereof include wet-type methods, dry-type methods, and other methods (for example, methods described in Chemical Review, Vol. 110, p. 6595 (published on 2010)). In these methods, it is preferable to apply the dispersion (paste) onto the surface of the conductive support 11 or the surface of the blocking layer 14 and then fire the dispersion at a temperature of 100°C to 800°C for ten minutes to ten hours, for example, in the air. In such a case, it is possible to bring the fine particles into close contact with each other.

In a case in which firing is performed multiple times, the temperature of firing that is not the final firing (the non-final firing temperature) is preferably set to be lower than the temperature of the final firing (the final firing temperature). For example, in a case in which titanium oxide paste is used, the non-final firing temperature can be set in a range of 50°C to 300°C. In addition, the final firing temperature can be set to be higher than the non-firing firing temperature in a range of 100°C to 600°C. In a case in which a glass support is used as the support 11a, the firing temperature is preferably 60°C to 500°C.

The amount of a porous material applied to form the porous layer 12 is appropriately set depending on the film thickness of the porous layer 12, the number of times of coating, and the like and is not particularly limited. The amount of the porous material applied to square meter of the surface area of the conductive support 11 is, for example, preferably 0.5 to 500 g and more preferably 5 to 100 g.

In a case in which the electron transport layer 15 or the hole transport layer 16 is provided, the layer can be formed in the same manner as the hole transport layer 3 or the electron transport layer 4 described below.

Next, the photosensitive layer 13 is provided.

A method for providing the photosensitive layer 13 is not particularly limited, and examples thereof include wet-type methods and dry-type methods. In the present invention, wet-type methods are preferred, and, for example, a method in which the surface is brought into contact with a light absorber solution including the absorber is preferred. In this method, first, the light absorber solution for forming the photosensitive layer 13 is prepared. The light absorber solution includes $MX_2$ and AX which are raw materials of the perovskite compound. Here, A, M, and X are the same as A, M, and X in Formula (I). In this light absorber solution, the molar ratio between $MX_2$ and AX is appropriately adjusted depending on the purpose. In a case in which a perovskite compound is formed as the light absorber, the molar ratio between $MX_2$ and AX is preferably 1:1 to 10:1. The light absorber solution can be prepared by mixing AX and $MX_2$ in a predetermined molar ratio and then, preferably, heating the components. This forming liquid is generally a solution, but may be a suspension. Heating conditions are not particularly limited, but the heating temperature is preferably 30°C to 200°C and more preferably 60°C to 150°C. The heating duration is preferably 0.5 to 100 hours and more preferably 1 to 3 hours. As a solvent or a dispersion medium, substances described below can be used.

Next, the prepared light absorber solution is brought into contact with the surface of a layer forming the photosensitive layer 13 on the surface thereof (in the photoelectric conversion element 10, any layer of the porous layer 12,

the blocking layer 14, the electron transport layer 15, or the hole transport layer 16). Specifically, it is preferable to apply the light absorber solution onto the surface or immerse the surface in the forming liquid. Therefore, a perovskite compound is formed (deposited, adsorbed, or the like) on the surface of the porous layer 12, the blocking layer 14, the electron transport layer 15, or the hole transport layer 16. The temperature at which the forming liquid is brought into contact with the surface is preferably 5°C to 100°C, and the immersion duration is preferably 5 seconds to 24 hours and more preferably 20 seconds to 1 hour. In a case in which the applied light absorber solution is dried, the forming liquid is preferably dried using heat and is generally dried by being generally heated at 20°C to 300°C and being preferably heated at 50°C to 170°C.

In addition, it is also possible to for the photosensitive layer according to a method for synthesizing the above-described perovskite compound.

Furthermore, examples thereof also include a method in which an AX solution including the AX and an $MX_2$ solution including the $MX_2$ are separately applied (including the immersion method) and are dried as necessary. In this method, any solution may be applied in advance, but the $MX_2$ solution is preferably applied in advance. In this method, the molar ratio between AX and $MX_2$, coating conditions, and drying conditions are the same as those in the above-described method. In this method, instead of applying the AX solution and the $MX_2$ solution, it is also possible to vapor-deposit AX or $MX_2$.

Furthermore, as another method, it is possible to use a dry-type method such as vapor deposition in a vacuum in which a compound or a mixture obtained by removing the solvent from the light absorber solution is used. For example, it is possible to use a method in which the AX and the $MX_2$ are simultaneously or sequentially vapor-deposited.

Therefore, the light absorber is formed and turns into the photosensitive layer 13.

In the manufacturing method of the present invention, next, the compound AC is provided on the surface of the first electrode.

In order to provide the compound AC on the surface of the first electrode, a liquid containing the compound AC is used. This liquid may be a liquid-form compound AC or may be a solution or a suspension (dispersion liquid). Solvents or dispersants are not particularly limited, examples thereof include solvents or dispersants described below, and isopropanol is preferred. The concentration of the compound AC in the liquid is not particularly limited, but is, for examples, preferably 0.01 to 100% by mass and more preferably 0.1 to 1% by mass.

The method for bringing the prepared liquid into contact with the surface of the first electrode is not particularly limited, and examples thereof include a method in which the liquid is applied to the surface of the first electrode and a method in which the first electrode is immersed in the liquid. Examples of the coating method include a variety of methods described below.

The coating or immersion temperature is preferably 5°C to 100°C. When the coating or immersion temperature is in the above-described range, it is considered that the structure of the perovskite layer can be maintained.

The immersion duration is preferably 0.1 seconds to 24 hours and more preferably 5 seconds to 1 hour.

After the coating or immersion, the liquid is preferably dried. The drying conditions are not particularly limited. The drying temperature is, for example, preferably 20°C to 200°C and more preferably 25°C to 120°C. The drying duration is, for example, preferably 1 minute to 10 hours and more preferably 5 minutes to I hour.

In this step, the amount of the compound AC applied is appropriately determined depending on the kind and the like of the compound AC and is not particularly limited. In the present invention, the amount is determined so that at least some of the surface of the first electrode is covered with the compound AC (the compound layer 5) in the above-described amount present.

On the first electrode on which the compound layer is formed as described above, preferably, the hole transport layer 3 or the electron transport layer 4 is formed.

The hole transport layer 3 can be formed by applying and drying a hole-transporting material solution including a hole-transporting material. In the hole-transporting material solution, the concentration of the hole-transporting material is preferably 0.1 to 1.0 M (mol/L) since coatability is excellent and, in a case in which the porous layer 12 is provided, the hole-transporting material is capable of easily intruding into the inside of pores in the porous layer 12.

The electron transport layer 4 can be formed by applying and drying an electron-transporting material solution including an electron-transporting material.

After the hole transport layer 3 or the electron transport layer 4 is formed, the second electrode 2 is formed, thereby manufacturing the photoelectric conversion element.

The film thicknesses of the respective layers can be adjusted by appropriately changing the concentrations of the respective dispersion liquids or solutions and the number of times of coating. For example, in a case in which the photosensitive layers 13B and 13C having a thick film thickness are provided, the light absorber solution may be applied and dried multiple times.

The respective dispersion liquids and solutions described above may respectively include additives such as a dispersion aid and a surfactant.

Examples of the solvent or dispersion medium that is used in the method for manufacturing the photoelectric

conversion element and the solar cell include solvents described in JP2001-291534A, but the solvent or dispersion medium is not limited thereto. In the present invention, organic solvents are preferred, and alcohol solvents, amide solvents, nitrile solvents, hydrocarbon solvents, lactone solvents, halogen solvents, sulfide solvents, and solvent mixtures of two or more thereof are preferred. The solvent mixture is preferably a solvent mixture of an alcohol solvent and a solvent selected from amide solvents, nitrile solvents, and hydrocarbon solvents. Specifically, methanol, ethanol, isopropanol, $\gamma$-butyrolactone, n-propylsulfide, chlorobenzene, acetonitrile, dimethylformamide (DMF) or dimethylacetamide, or a solvent mixture thereof is preferred.

A method for applying the solutions or dispersants used to form the respective layers is not particularly limited, and it is possible to use a well-known coating method such as spin coating, extrusion die coating, blade coating, bar coating, screen printing, stencil printing, roll coating, curtain coating, spray coating, dip coating, an inkjet printing method, or an immersion method. Among these, a spin coating method, a screen printing method, an immersion method, and the like are preferred.

The photoelectric conversion element of the present invention may be subjected to an efficiency-stabilizing treatment such as annealing, light soaking, or being left to stand in an oxygen atmosphere as necessary.

The photoelectric conversion element produced as described above can be used as a solar cell by connecting the external circuit 6 to the first electrode 1 (the transparent electrode 11b) and the second electrode 2.

Examples

Hereinafter, the present invention will be described in more detail on the basis of examples, but the present invention is not limited thereto.

Synthesis examples

Individual compounds AC, thiophene, and pyridine which were used in examples described below were prepared.

Compounds AC that could not be procured were synthesized according to the methods described in the following documents.

For example, documents which were referred to for the syntheses of the following compounds will be described below.

Compounds AC-3 and AC-11: tetrahedron, 2013, vol 69, No. 38, pp. 8191 to 8198

Compound AC-5: Organic Letters, 2011, vol 13, No. 20, pp. 5464 to 5467

Compound AC-14: Journal of Agricultural and Food Chemistry, 2009, vol. 57, No. 20, pp. 9607 to 9612

Compound AC-15: Organic and Biomolecular Chemistry, 2014, vol. 12, No. 34, pp. 6661 to 6671

Compound AC-17: Organic Letters, 2001, vol. 3, No. 19, 2,997-2,999, and Journal of Fluorine Chemistry, 1990, vol. 46, No. 3, pp. 423 to 431

Compound AC-19: Tetrahedron Letters, 2011, vol. 52, No. 38, pp. 4965 to 4966

Compound AC-22: European Journal of Organic Chemistry, 2008, No. 21, pp. 3668 to 3672

Compound AC-23: Heterocycles, 1997, vol. 46, No. 1,209-214, and Chemical Communications, 2005, No. 26, pp. 3295 to 3297

Example 1

(Manufacturing of photoelectric conversion element (Specimen Number 101))

The photoelectric conversion element 10A illustrated in Fig. 1 was manufactured in an order described below. Meanwhile, in a case in which the film thickness of the photosensitive layer 13 is large, the photoelectric conversion element corresponds to the photoelectric conversion element 10B illustrated in Fig. 2.

<Production of conductive support 11>

A fluorine-doped $SnO_2$ conductive film (the transparent electrode 11b, a film thickness: 300 nm) was formed on a glass substrate (the support 11a, thickness: 2 mm), thereby producing a conductive support 11.

<Preparation of solution for blocking layer>

An isopropanol solution containing 15% by mass of titanium diisopropoxide bis(acetylacetonate) (manufactured by Sigma-Aldrich Japan K.K.) was diluted with 1-butanol, thereby preparing 0.02 M of a solution for a blocking layer.

<Formation of blocking layer 14>

A blocking layer 14 made of titanium oxide (having a film thickness of 50 nm) was formed on the $SnO_2$ conductive film of the conductive support 11 using 0.02 M of the solution for the blocking layer at 450°C by means of a spray thermal decomposition method.

<Preparation of titanium oxide paste>

Ethyl cellulose, lauric acid, and terpineol were added to an ethanol dispersion liquid of titanium oxide (anatase, an average particle diameter of 20 nm), thereby preparing titanium oxide paste.

<Formation of porous layer 12>

The prepared titanium oxide paste was applied onto the blocking layer 14 by means of a screen printing method and was fired in the air at 500°C for three hours. After that, the obtained titanium oxide fired body was immersed in an aqueous solution of 40 mM of $TiCl_4$, then, was heated at 60°C for one hour, and, continuously, was heated at 500°C for 30 minutes, thereby forming the porous layer 12 (having a film thickness of 250 nm) made of $TiO_2$.

<Formation of photosensitive layer 13A>

A 40% methanol solution of methyl amine (27.86 mL) and an aqueous solution of 57% by mass of hydrogen iodide (hydroiodic acid, 30 mL) were stirred in a flask at 0°C for two hours and then condensed, thereby obtaining a $CH_3NH_3I$ coarse body. The obtained $CH_3NH_3I$ coarse body was dissolved in ethanol and was recrystallized with diethyl ether, and the obtained crystals were filtered and were dried at 60°C for five hours under reduced pressure, thereby obtaining purified $CH_3NH_3I$.

Next, the molar ratio between the purified $CH_3NH_3I$ and $PbI_2$ were stirred and mixed together at 60°C in DMF for 12 hours at a molar ratio of 3:1 and then filtered using a polytetrafluoroethylene (PTFE) syringe filter, thereby preparing 40% by mass of a light absorber solution A.

The prepared light absorber solution A was applied onto the porous layer 12 formed on the conductive support 11 using a spin coating method (at 2,000 rpm for 60 seconds), and the light absorber solution A was dried at 100°C for 60 minutes using a hot plate, thereby providing the photosensitive layer 13A made of a perovskite compound of $CH_3NH_3PbI_3$ (having a film thickness of 300 nm (including the film thickness of the porous layer 12 of 250 nm)).

A first electrode 1A was produced in the above-described manner.

<Formation of compound layer 5A>

Next, a 0.1% by mass isopropanol solution (80 μL) of Compound AC-1 was applied to the surface of a 25 mm×25 mm first electrode 1A using a spin coating method (at 3,000 rpm for 30 seconds), and then the applied solution was dried at 100°C for 30 minutes using a hot plate. A compound layer 5A was formed in the above-described manner.

Here, the surface of the first electrode 1A to which the isopropanol solution containing Compound AC-1 was applied was checked using HPLC in the above-described manner, and it was found that 1.8 mg/$m^2$ of Compound AC-1 was present on the surface of the photosensitive layer 13A.

<Preparation of hole-transporting material solution>

Spiro-OMeTAD (180 mg) as a hole-transporting material was dissolved in chlorobenzene (1 mL). An acetonitrile solution (37.5 μL) obtained by dissolving lithium-bis(trifluoromethanesulfonyl)imide (170 mg) in acetonitrile (1 mL) and t-butylpyridine (TBP, 17.5 μL) were added to and mixed with the chlorobenzene solution, thereby preparing a solution for the hole transport layer.

<Formation of hole transport layer 3A>

Next, the prepared solution for the hole transport layer was applied onto the compound layer 5A formed on the surface of the first electrode 1A using a spin coating method and dried, thereby forming a solid-form hole transport layer 3A (having a film thickness of 100 nm).

<Production of second electrode 2>

Gold was vapor-deposited on the hole transport layer 3A using a vapor deposition method, thereby producing a second electrode 2 (having a film thickness of 100 nm).

The photoelectric conversion element 10A (Specimen Number 101) was manufactured in the above-described manner.

The respective film thicknesses were measured according to the above-described method by means of observation using SEM.

(Manufacturing of photoelectric conversion elements (Specimen Numbers. 102 to 119 and c01 and c02))

Photoelectric conversion elements (with Specimen Numbers 102 to 119) of the present invention and photoelectric conversion elements (with Specimen Numbers c01 and c02) for comparison were respectively manufactured in the same manner as in the manufacturing of the photoelectric conversion element (with Specimen Number 101) except for the fact that, in the manufacturing of the photoelectric conversion element (with Specimen Number 101), isopropanol solutions respectively containing the compounds shown in the "Compound represented by Formula (AC) column" in Table 1 instead of Compound AC-1 were used or an isopropanol solution containing Compound AC-1 was not applied (for Specimen Number c02).

For Specimen Numbers 102 to 119, it was confirmed that, after the formation of the compound layer 5A, the respective compounds AC were present on the surface of the first electrode 1A.

(Manufacturing of photoelectric conversion element (Specimen Number 120))

A photoelectric conversion element (with Specimen Number 120) of the present invention was manufactured in the same manner as in the manufacturing of the photoelectric conversion element (with Specimen Number 101) except for the fact that, in the manufacturing of the photoelectric conversion element (with Specimen Number 101), the photosensitive layer 13A was formed using Compound AC-2 instead of Compound AC-1, the following light absorber solution B instead of the light absorber solution A, and the following method.

It was confirmed that, after the formation of the compound layer 5A, Compound AC-2 was present on the surface of the first electrode 1A.

<Preparation of light absorber solution B>

A 40% ethanol solution of ethylamine (36 g) and an aqueous solution of 57% by mass of hydrogen iodide (hydroiodic acid, 72 g) were stirred in a flask at 0°C for two hours and then condensed, thereby obtaining a $CH_3CH_2NH_3I$ coarse body. The obtained $CH_3CH_2NH_3I$ coarse body was dissolved in ethanol and was recrystallized with diethyl ether. The precipitated crystals were filtered and were dried at 60°C for 12 hours under reduced pressure, thereby obtaining purified $CH_3CH_2NH_3I$. Next, the molar ratio between the purified $CH_3CH_2NH_3I$ and $PbI_2$ was set to 2:1, the components were stirred and mixed together at 60°C in DMF for five hours and then filtered using a PTFE syringe filter, thereby preparing 40% by mass of a light absorber solution B.

The prepared light absorber solution B was applied onto the porous layer 12 using a spin coating method (at 2,000 rpm for 60 seconds), and then the applied light absorber solution B was dried at 140°C for 40 minutes using a hot plate, thereby providing a photosensitive layer 13A (having a film thickness of 300 nm (including the film thickness of the porous layer 12 of 250 nm)) made of a perovskite compound of $(CH_3CH_2NH_3)_2PbI_4$.

(Manufacturing of photoelectric conversion element (Specimen Number 121))

A photoelectric conversion element (with Specimen Number 121) of the present invention was manufactured in the same manner as in the manufacturing of the photoelectric conversion element (with Specimen Number 112) except for the fact that, in the manufacturing of the photoelectric conversion element (with Specimen Number 112), the following light absorber solution C was used instead of the light absorber solution A.

The obtained photosensitive layer contained a perovskite compound represented by $CH_3NH_3PbI_{(3-n)}Cl_n$ (n represents a number of 0.001 to 2).

It was confirmed that, after the formation of the compound layer 5A, Compound AC-15 was present on the surface of the first electrode 1A.

<Preparation of light absorber solution C>

A 40% methanol solution of methylamine (27.86 mL) and an aqueous solution of 57% by mass of hydrogen iodide (hydroiodic acid, 30 mL) were stirred in a flask at 0°C for two hours and then condensed, thereby obtaining a $CH_3NH_3I$ coarse body. The obtained $CH_3NH_3I$ coarse body was dissolved in ethanol, was recrystallized with diethyl ether, the obtained crystals were filtered, and were dried at 60°C for five hours under reduced pressure, thereby obtaining purified $CH_3NH_3I$. Next, the purified $CH_3NH_3I$ and PbCl2 were stirred and mixed together at a molar ratio of 3:1 at 60°C in DMF for 12 hours and then filtered using a PTFE syringe filter, thereby preparing 40% by mass of a light absorber solution C.

(Manufacturing of photoelectric conversion element (Specimen Number c03))

A photoelectric conversion element (with Specimen Number c03) for comparison was manufactured in the same manner as in the manufacturing of the photoelectric conversion element (with Specimen Number 121) except for the fact that, in the manufacturing of the photoelectric conversion element (with Specimen Number 121), an isopropanol solution containing Compound AC-15 was not applied.

(Manufacturing of photoelectric conversion element (Specimen Number c04))

A photoelectric conversion element (with Specimen Number c04) for comparison was manufactured in the same manner as in the manufacturing of the photoelectric conversion element (with Specimen Number 121) except for the fact that, in the manufacturing of the photoelectric conversion element (with Specimen Number 121), an isopropanol solution containing pyridine instead of Compound AC-15 was used.

[Evaluation of durability]

Ten testing pieces of the photoelectric conversion element with each specimen number were manufactured in the same manner as the above-described manufacturing method. Cell characteristics testing was carried out on the ten testing pieces respectively, and currents were measured. In addition, the average value of the values of these ten testing pieces was considered as the initial current of the photoelectric conversion element with each specimen number. The cell characteristics testing was carried out by radiating 1,000 W/$m^2$ of quasi-sunlight from a xenon lamp through an AM1.5 filter using a solar simulator "WXS-85H" (Wacom). Current-voltage characteristics were measured using an I-V tester.

Next, ten testing pieces of each specimen number were left to stand in a constant temperature and humidity tank with a humidity of 50RH% and a temperature of 30°C for 30 hours respectively, then, cell characteristics testing was carried out in the same manner as described above, and currents were measured. The average value of the values of the ten testing pieces was considered as the current of the photoelectric conversion element with each specimen number after being left to stand.

The durability of the photoelectric conversion element was evaluated from the decline percentage of the current computed using the following expression according to the following evaluation standards. In the durability evaluation standards, [C] and higher are pass levels of the present testing. The results are shown in Table 1.

$$\text{Decline percentage (\%)} = [(\text{initial current} - \text{current after being left to stand})/(\text{initial current})] \times 100$$

- Durability evaluation standards -

A: The decline percentage is less than 20%
B+: The decline percentage is 20% or more and less than 24%
B: The decline percentage is 24% or more and less than 28%
C+: The decline percentage is 28% or more and less than 32%
C: The decline percentage is 32% or more and less than 36%
D+: The decline percentage is 36% or more and less than 40%
D: The decline percentage is 40% or more

[Table 1]

| Specimen number | Formula (I) | | | Compound represented by Formula (AC) | Durability | Note |
|---|---|---|---|---|---|---|
| | $A(R^{1a}\text{-}NH_3)$ | M | X | | | |
| 101 | $CH_3NH_3$ | Pb | I | AC-1 | B | Present Invention |
| 102 | $CH_3NH_3$ | Pb | I | AC-2 | A | Present Invention |
| 103 | $CH_3NH_3$ | Pb | I | AC-3 | B | Present Invention |
| 104 | $CH_3NH_3$ | Pb | I | AC-4 | B+ | Present Invention |
| 105 | $CH_3NH_3$ | Pb | I | AC-5 | B | Present Invention |
| 106 | $CH_3NH_3$ | Pb | I | AC-8 | C+ | Present Invention |
| 107 | $CH_3NH_3$ | Pb | I | AC-10 | B+ | Present Invention |
| 108 | $CH_3NH_3$ | Pb | I | AC-11 | C+ | Present Invention |
| 109 | $CH_3NH_3$ | Pb | I | AC-12 | B+ | Present Invention |
| 110 | $CH_3NH_3$ | Pb | I | AC-13 | C+ | Present Invention |
| 111 | $CH_3NH_3$ | Pb | I | AC-14 | A | Present Invention |
| 112 | $CH_3NH_3$ | Pb | I | AC-15 | A | Present Invention |
| 113 | $CH_3NH_3$ | Pb | I | AC-16 | A | Present Invention |
| 114 | $CH_3NH_3$ | Pb | I | AC-17 | A | Present Invention |
| 115 | $CH_3NH_3$ | Pb | I | AC-19 | A | Present Invention |
| 116 | $CH_3NH_3$ | Pb | I | AC-20 | B+ | Present Invention |
| 117 | $CH_3NH_3$ | Pb | I | AC-21 | B+ | Present Invention |
| 118 | $CH_3NH_3$ | Pb | I | AC-22 | B+ | Present Invention |
| 119 | $CH_3NH_3$ | Pb | I | AC-23 | B+ | Present Invention |
| 120 | $(CH_3CH_2NH_3)_2$ | Pb | I | AC-2 | A | Present Invention |
| 121 | $CH_3NH_3$ | Pb | $I_{(3-n)}Cl_n$ | AC-15 | A | Present Invention |
| c01 | $CH_3NH_3$ | Pb | I | Thiophene | D+ | Comparative Example |
| c02 | $CH_3NH_3$ | Pb | I | None | D | Comparative Example |
| c03 | $CH_3NH_3$ | Pb | $I_{(3-n)}Cl_n$ | None | D | Comparative Example |
| c04 | $CH_3NH_3$ | Pb | $I_{(3-n)}Cl_n$ | Pyridine | D+ | Comparative Example |
| In Table 1, n represents a number of 0.001 to 2. | | | | | | |

The results in Table 1 show the following facts.

That is, in all of the photoelectric conversion elements of the present invention including the compound AC (the compound layer) on the surface of the first electrode, the decline percentages of the current were small, and excellent durability was exhibited even when the perovskite compound was used as the light absorber in the photoelectric conversion elements.

Durability as excellent as described above could also be obtained in photoelectric conversion elements in which a perovskite compound containing a chlorine atom and an iodine atom as the anionic atoms was used as the light absorber.

Particularly, in a case in which $n_A$ in Formula (AC) was zero and $R^{AC}$ was a halogen atom, an alkyl group having 5 or more carbon atoms, or the group having a halogen atom (halogenated alkyl group), the durability-improving effect was significant. In addition, in a case in which $n_A$ in Formula (AC) was zero and Z was an oxygen atom, particularly, in

a case in which the ring $A^{AC}$ in Formula (AC) was a furan ring, the durability-improving effect became more significant.

In contrast, in all of the photoelectric conversion elements (with Specimen Numbers c01 and c04) in which a perovskite compound was used as the light absorber and the surface of the first electrode was treated with thiophene or pyridine and the photoelectric conversion elements (with Specimen Numbers c02 and c03) in which a perovskite compound was used as the light absorber and the specific compound AC was not present on the surface of the first electrode, the decline percentages of the current were great, and the durability was not sufficient.

Example 2

(Manufacturing of photoelectric conversion element (Specimen Number 201))

A photoelectric conversion element 10A illustrated in Fig. 1 was manufactured in the same manner as in Example 1 in the following order.

A photoelectric conversion element (with Specimen Number 201) of the present invention was manufactured in the same manner as in the manufacturing of the photoelectric conversion element (with Specimen Number 112) except for the fact that, in the manufacturing of the photoelectric conversion element (with Specimen Number 112), the photosensitive layer 13A was formed using the following light absorber solution D instead of the light absorber solution A and the following method.

It was confirmed that, after the formation of the compound layer 5A, Compound AC-15 was present on the surface of the first electrode 1A.

<Preparation of light absorber solution D>

A 40% methanol solution of methylamine (27.86 mL) and an aqueous solution of 57% by mass of hydrogen iodide (hydroiodic acid, 30 mL) were stirred in a flask at 0°C for two hours and then condensed, thereby obtaining a $CH_3NH_3I$ coarse body. The obtained $CH_3NH_3I$ coarse body was dissolved in ethanol, was recrystallized with diethyl ether, the obtained crystals were filtered, and were dried at 60°C for five hours under reduced pressure, thereby obtaining purified $CH_3NH_3I$. Next, the purified $CH_3NH_3I$, $PbI_2$, and $SnI_2$ were stirred and mixed together at molar ratios among 2:0.9:0.1 at 60°C in γ-butyrotactone for 12 hours and then filtered using a PTFE syringe filter, thereby preparing 40% by mass of a light absorber solution D.

The prepared light absorber solution D was applied onto the porous layer 12 using a spin coating method (at 2,000 rpm for 60 seconds and subsequently at 3,000 rpm for 60 seconds), and then the applied light absorber solution D was dried at 100°C for 80 minutes using a hot plate, thereby forming a photosensitive layer 13A made of a perovskite compound of $CH_3NH_3Pb_{0.9}Sn_{0.1}I_3$.

(Manufacturing of photoelectric conversion element (Specimen Number c21))

A photoelectric conversion element (with Specimen Number c21) for comparison was manufactured in the same manner as in the manufacturing of the photoelectric conversion element (with Specimen Number 201) except for the fact that, in the manufacturing of the photoelectric conversion element (with Specimen Number 201), an isopropanol solution containing Compound AC-15 was not applied to the surface of the first electrode 1A.

[Evaluation of durability]

For the photoelectric conversion element with each specimen number (ten testing pieces) manufactured above, the durability was evaluated in the same manner as in <the evaluation of durability> of Example 1 except for the fact that the testing pieces were left to stand in a constant temperature and humidity container with a humidity of 10RH% and a temperature of 20°C for 10 hours respectively. In the durability evaluation standards, [C] and higher are pass levels of the present testing. The results are shown in Table 2.

[Table 2]

| Specimen number | Formula (1) | | | Compound represented by Formula (AC) | Durability | Note |
|---|---|---|---|---|---|---|
| | A ($R^{1a}$-$NH_3$) | M | X | | | |
| 201 | $CH_3NH_3$ | $Pb_{0.9}Sn_{0.1}$ | I | AC-15 | B | Present Invention |

(continued)

| Specimen number | Formula (1) | | | Compound represented by Formula (AC) | Durability | Note |
|---|---|---|---|---|---|---|
| | A ($R^{1a}$-$NH_3$) | M | X | | | |
| c21 | $CH_3NH_3$ | $Pb_{0.9}Sn_{0.1}$ | I | None | D | Comparative Example |

As is clear from the results of Table 2, even in photoelectric conversion elements in which a perovskite compound containing tin and lead as the metallic atoms was used as the light absorber, sufficient durability was obtained.
On the other hand, in photoelectric conversion elements in which the specific compound AC was not provided on the surface of the first electrode, the durability was not sufficient.

Example 3

(Manufacturing of photoelectric conversion element (Specimen Number 301))

A photoelectric conversion element 10C illustrated in Fig. 3 was manufactured in the following order.
A photoelectric conversion element 10C (with Specimen Number 301) of the present invention was manufactured in the same manner as in the manufacturing of the photoelectric conversion element (with Specimen Number 112) except for the fact that, in the manufacturing of the photoelectric conversion element (with Specimen Number 112), the porous layer 12 was not provided, the photosensitive layer 13C was provided on the blocking layer 14, and the film thicknesses of the photosensitive layer 13C and the hole transport layer 3B were respectively changed to the following film thicknesses.
In the photoelectric conversion element 10C (with Specimen Number 301), the film thickness of the photosensitive layer 13C was 250 nm, and the film thickness of the hole transport layer 3B was 100 nm.
It was confirmed that, after the formation of the compound layer 5B, Compound AC-15 was present on the surface of the first electrode 1C.

(Manufacturing of photoelectric conversion element (Specimen Number c31))

A photoelectric conversion element (with Specimen Number c31) for comparison was manufactured in the same manner as in the manufacturing of the photoelectric conversion element (with Specimen Number 301) except for the fact that, in the manufacturing of the photoelectric conversion element (with Specimen Number 301), an isopropanol solution containing Compound AC-15 was not applied to the surface of the first electrode 1C.

<Evaluation of durability>

For the photoelectric conversion element with each specimen number (ten testing pieces) manufactured above, the durability was evaluated in the same manner as in <the evaluation of durability> of Example 1. The results are shown in Table 3.

[Table 3]

| Specimen number | Formula (I) | | | Compound represented by Formula (AC) | Durability | Note |
|---|---|---|---|---|---|---|
| | A($R^{1a}$-$NH_3$) | M | X | | | |
| 301 | $CH_3NH_3$ | Pb | I | AC-15 | A | Present Invention |
| c31 | $CH_3NH_3$ | Pb | I | None | D | Comparative Example |

As is clear from the results of Table 3, it was found that, even in photoelectric conversion elements in which a perovskite compound was used as the light absorber, excellent durability was exhibited even when the porous layer was not provided.
On the other hand, in photoelectric conversion elements in which the specific compound AC was not provided on the surface of the first electrode, the durability was not sufficient.

Example 4

(Manufacturing of photoelectric conversion element (Specimen Number 401))

A photoelectric conversion element 10E illustrated in Fig. 5 was manufactured in the following order.

<Production of conductive support 11>

A tin-doped indium oxide film (ITO, the transparent electrode 11b, a film thickness: 300 nm) was formed on a glass substrate (the support 11a, thickness: 2 mm), thereby producing a conductive support 11.

<Formation of hole transport layer 16>

Poly(3,4-ethylenedioxythiophene)-poly(styrene sulfonate) (PEDOT-PSS) was dissolved in a solvent mixture of water and isopropyl alcohol (IPA), thereby preparing a solution for the hole transport layer (the concentration of PEDOT-PSS: 1% by mass).
The solution for the hole transport layer was applied onto the ITO film 11b in the conductive support 11 using a spin coating method and dried at 120°C for 30 minutes using a hot plate, thereby forming a film of a hole transport layer 16 (having a film thickness of 50 nm).

<Formation of photosensitive layer 13C>

A photosensitive layer 13C (having a film thickness of 200 nm) made of a perovskite compound of $CH_3NH_3PbI_3$ was provided in the same manner as in the <formation of photosensitive layer 13A> during the manufacturing of the photoelectric conversion element (with Specimen Number 101) except for the fact that the solvent was changed to γ-butyrolactone on the formed hole transport layer 16. The first electrode 1E was produced in the above-described manner.

<Formation of compound layer 5B>

Next, a 0.1% by mass isopropanol solution of Compound AC-15 was applied to the surface of the first electrode 1E using a spin coating method (at 3,000 rpm for 30 seconds), and then the applied solution was dried at 100°C for 30 minutes using a hot plate. A compound layer 5B was formed in the above-described manner.
Here, the amount of the isopropanol solution applied was the same as the amount of the 0.1% by mass isopropanol solution of Compound AC-1 applied in Example 1. In addition, as a result of checking the surface of the first electrode 1E to which the isopropanol solution containing Compound AC-15 was applied as described above, Compound AC-15 was present on the surface of the photosensitive layer 13C.

<Formation of electron transport layer 4>

Next, a chlorobenzene solution of $PC_{61}BM$ (having a concentration of $PC_{61}BM$ of 1% by mass) was applied to the surface of the first electrode 1E using a spin coating method (at 1,500 rpm for 60 seconds), thereby forming an electron transport layer 4 (having a film thickness of 50 nm).

<Production of second electrode 2>

Aluminum was vapor-deposited on the electron transport layer 4 using a vapor deposition method, thereby producing a second electrode 2 (having a film thickness of 100 nm).
A photoelectric conversion element 10E (with Specimen Number 401) was manufactured in the above-described manner.

(Manufacturing of photoelectric conversion element (Specimen Number c41))

A photoelectric conversion element (with Specimen Number c41) for comparison was manufactured in the same manner as in the manufacturing of the photoelectric conversion element (with Specimen Number 401) except for the fact that, in the manufacturing of the photoelectric conversion element (with Specimen Number 401), an isopropanol solution containing Compound AC-15 was not applied to the surface of the first electrode 1E.

<Evaluation of durability>

For the photoelectric conversion element with each specimen number (ten testing pieces) manufactured above, the durability was evaluated in the same manner as in <the evaluation of durability> of Example 1. The results are shown in Table 4.

[Table 4]

| Specimen number | Formula (I) | | | Compound represented by Formula (AC) | Durability | Note |
|---|---|---|---|---|---|---|
| | $A(R^{1a}-NH_3)$ | M | X | | | |
| 401 | $CH_3NH_3$ | Pb | I | AC-15 | B | Present Invention |
| c41 | $CH_3NH_3$ | Pb | I | None | D | Comparative Example |

As is clear from the results of Table 4, it was found that, in photoelectric conversion elements in which a perovskite compound was used as the light absorber, sufficient durability was exhibited even when a structure in which the hole transport layer 16, the photosensitive layer 13C, the compound layer 5B, the electron transport layer 4, and the second electrode 2 were formed on the conductive support 11 in this order was provided.

On the other hand, in photoelectric conversion elements in which the specific compound AC was not provided on the surface of the first electrode, the durability was not sufficient.

Example 5

(Manufacturing of photoelectric conversion element (Specimen Number 501))

A photoelectric conversion element not including a hole transport layer (refer to the photoelectric conversion element 10F illustrated in Fig. 6) was manufactured in the following order.

A photoelectric conversion element (with Specimen Number 501) of the present invention was manufactured in the same manner as in the manufacturing of the photoelectric conversion element (with Specimen Number 112) except for the fact that, in the manufacturing of the photoelectric conversion element (with Specimen Number 112), the hole transport layer 3A was not provided and the second electrode 2 was not provided on the first electrode (the compound layer 5).

It was confirmed that, after the formation of the compound layer, Compound AC-15 was present on the surface of the first electrode.

(Manufacturing of photoelectric conversion element (Specimen Number c51))

A photoelectric conversion element (with Specimen Number c51) for comparison was manufactured in the same manner as in the manufacturing of the photoelectric conversion element (with Specimen Number 501) except for the fact that, in the manufacturing of the photoelectric conversion element (with Specimen Number 501), an isopropanol solution containing Compound AC-15 was not applied to the surface of the first electrode 1F.

<Evaluation of durability>

For the photoelectric conversion element with each specimen number (ten testing pieces) manufactured above, the durability was evaluated in the same manner as in <the evaluation of durability> of Example 1 except for the fact that the testing pieces were left to stand in a constant temperature and humidity container with a humidity of 30RH% and a temperature of 20°C for 20 hours respectively. The results are shown in Table 5.

[Table 5]

| Specimen number | Formula (I) | | | Compound represented by Formula (AC) | Durability | Note |
|---|---|---|---|---|---|---|
| | $A(R^{1a}-NH_3)$ | M | X | | | |
| 501 | $CH_3NH_3$ | Pb | I | AC-15 | B | Present Invention |

(continued)

| Specimen number | Formula (I) | | | Compound represented by Formula (AC) | Durability | Note |
|---|---|---|---|---|---|---|
| | $A(R^{1a}-NH_3)$ | M | X | | | |
| c51 | $CH_3NH_3$ | Pb | I | None | D | Comparative Example |

As is clear from the results of Table 5, it was found that, in photoelectric conversion elements in which a perovskite compound was used as the light absorber, sufficient durability was exhibited even when the hole transport layer was not provided.

On the other hand, in photoelectric conversion elements in which the specific compound AC was not provided on the surface of the first electrode, the durability was not sufficient.

As described above, it was found that, even in photoelectric conversion elements in which a perovskite compound was used as the light absorber, in a case in which Compound AC (the compound layer) was provided on the surface of the first electrode, excellent durability was exhibited.

The present invention has been described together with embodiments thereof, but the present inventors do not limit the present invention in any detailed part of the description unless particularly otherwise described and consider that the present invention is supposed to be widely interpreted within the scope of the concept of the present invention which is described in the accompanying claims.

The present application claims priority on the basis of JP2015-046440, filed on March 9, 2015, the contents of which are incorporated herein by reference.

Explanation of References

1A to 1F: first electrode
11: conductive support
11a: support
11b: transparent electrode
12: porous layer
13A to 13C: photosensitive layer
14: blocking layer
2: second electrode
3A, 3B, 16: hole transport layer
4, 15: electron transport layer
5A to 5C: compound layer
6: external circuit (lead)
10A to 10F: photoelectric conversion element
100A to 100F: system in which solar cell is used
M: electric motor

## Claims

**1.** A photoelectric conversion element comprising:

a first electrode having a photosensitive layer including a light absorber on a conductive support; and
a second electrode facing the first electrode,
wherein the light absorber includes a compound having a perovskite-type crystal structure including cations of an element belonging to Group I of the periodic table or a cationic organic group A, cations of a metallic atom M other than elements belonging to Group I of the periodic table, and anions of an anionic atom or atomic group X, and
a compound represented by Formula (AC) is provided on a surface of the first electrode,

Formula (AC)

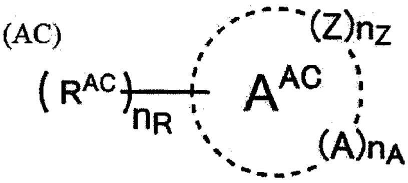

in the formula, a ring $A^{AC}$ represents a hetero ring, Z represents a sulfur atom or an oxygen atom, $n_Z$ represents an integer of 1 or more, A represents >C=$CR^{Y1}R^{Y2}$, >C=S, >C=O, or >C=$NR^{Y3}$, $R^{Y1}$ and $R^{Y2}$ each independently represent a substituent, $R^{Y3}$ represents a hydrogen atom or substituent, $n_A$ represents an integer of 0 or more, $R^{AC}$ represents a substituent, and $n_R$ represents an integer of 0 or more; here, when Z is a sulfur atom, and $n_Z$ is 1, $n_R$ represents an integer of 1 or more.

**2.** The photoelectric conversion element according to claim 1, wherein $R^{AC}$ is a halogen atom, an alkyl group having 5 or more carbon atoms, or a group having a halogen atom.

**3.** The photoelectric conversion element according to claim 1 or 2, wherein the ring $A^{AC}$ is a five-membered or six-membered aromatic hetero ring.

**4.** The photoelectric conversion element according to any one of claims 1 to 3, wherein at least one Z is an oxygen atom.

**5.** The photoelectric conversion element according to any one of claims 1 to 4, wherein the ring $A^{AC}$ is a furan ring.

**6.** The photoelectric conversion element according to any one of claims 1 to 5,

wherein the compound having a perovskite-type crystal structure is a compound represented by Formula (I),

Formula (I): $A_aM_mX_x$

in the formula, A represents an element belonging to Group I of the periodic table or a cationic organic group represented by Formula (1), M represents a metallic atom other than elements belonging to Group I of the periodic table, X represents an anionic atom or atomic group, a represents 1 or 2, m represents 1, and a, m, and x satisfy a+2m=x,

Formula (1): $R^{1a}$-$NH_3$

in the formula, $R^{1a}$ represents a substituent.

**7.** The photoelectric conversion element according to claim 6, wherein $R^{1a}$ is an alkyl group, a cycloalkyl group, an alkenyl group, an alkynyl group, an aryl group, a heteroaryl group, or a group that Formula (2) is capable of representing,

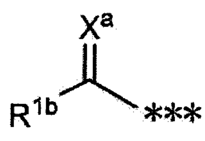

Formula (2)

in the formula, $X^a$ represents $NR^{1c}$, an oxygen atom, or a sulfur atom, $R^{1b}$ and $R^{1c}$ each independently represent a hydrogen atom or a substituent, *** represents a bond with a nitrogen atom in Formula (1).

**8.** The photoelectric conversion element according to any one of claims 1 to 7, wherein the metallic atom is at least one metallic atom selected from the group consisting of lead and tin.

**9.** The photoelectric conversion element according to any one of claims 1 to 8, further comprising:

a hole transport layer between the first electrode and the second electrode.

**10.** The photoelectric conversion element according to any one of claims 1 to 9, further comprising:

a porous layer between the conductive support and the photosensitive layer.

**11.** A solar cell using the photoelectric conversion element according to any one of claims 1 to 10.

**12.** A method for manufacturing a photoelectric conversion element, comprising:

bringing a first electrode having a photosensitive layer in which a compound having a perovskite-type crystal structure having cations of an element belonging to Group I of the periodic table or a cationic organic group A, cations of a metallic atom M other than elements belonging to Group I of the periodic table, and anions of an anionic atom or atomic group X is included as a light absorber on a conductive support into contact with a liquid containing a compound represented by Formula (AC),

Formula (AC)

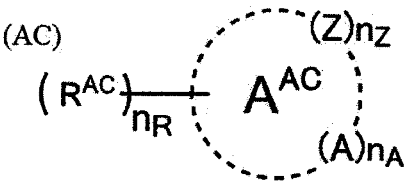

in the formula, a ring $A^{AC}$ represents a hetero ring, Z represents a sulfur atom or an oxygen atom, $n_z$ represents an integer of 1 or more, A represents >C=CR$^{Y1}$R$^{Y2}$, >C=S, >C=O, or >C=NR$^{Y3}$, $R^{Y1}$ and $R^{Y2}$ each independently represent a substituent, $R^{Y3}$ represents a hydrogen atom or substituent, $n_A$ represents an integer of 0 or more, $R^{AC}$ represents a substituent, and $n_R$ represents an integer of 0 or more; here, when Z is a sulfur atom, and $n_z$ is 1, $n_R$ represents an integer of 1 or more.

FIG. 1

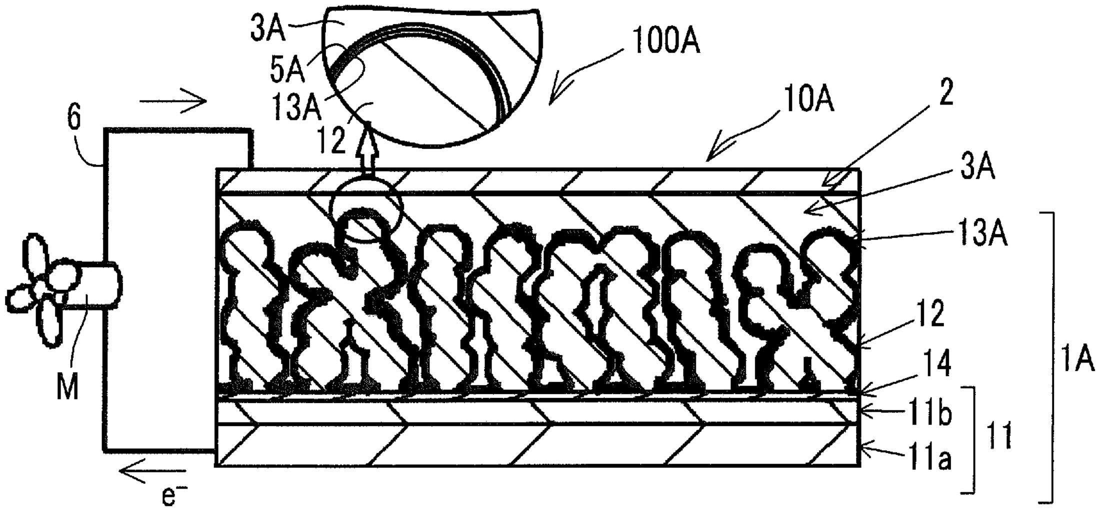
3A
5A
13A
12
100A
6
10A
2
3A
13A
12
14
11b
11a
11
1A
M
e⁻

FIG. 2

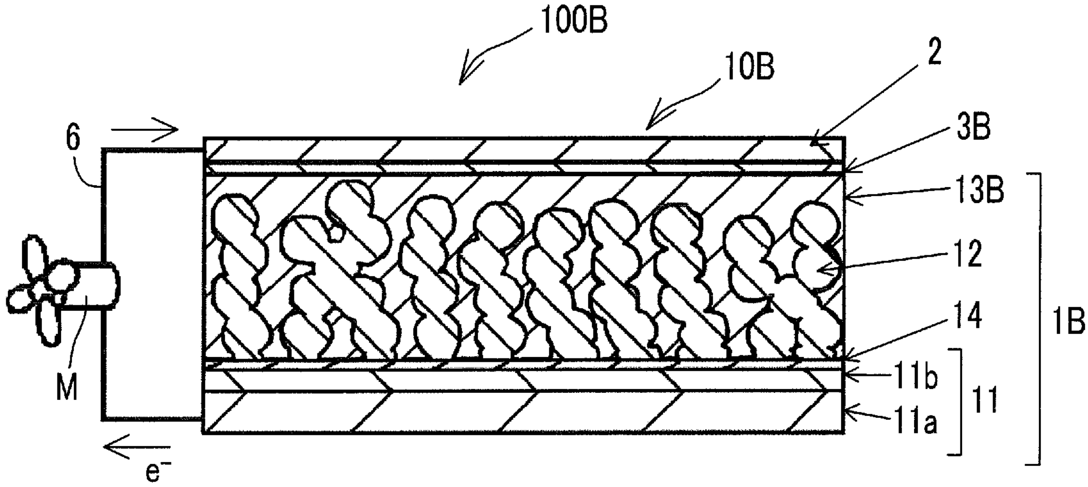
100B
10B
2
6
3B
13B
12
14
11b
11a
11
1B
M
e⁻

FIG. 3

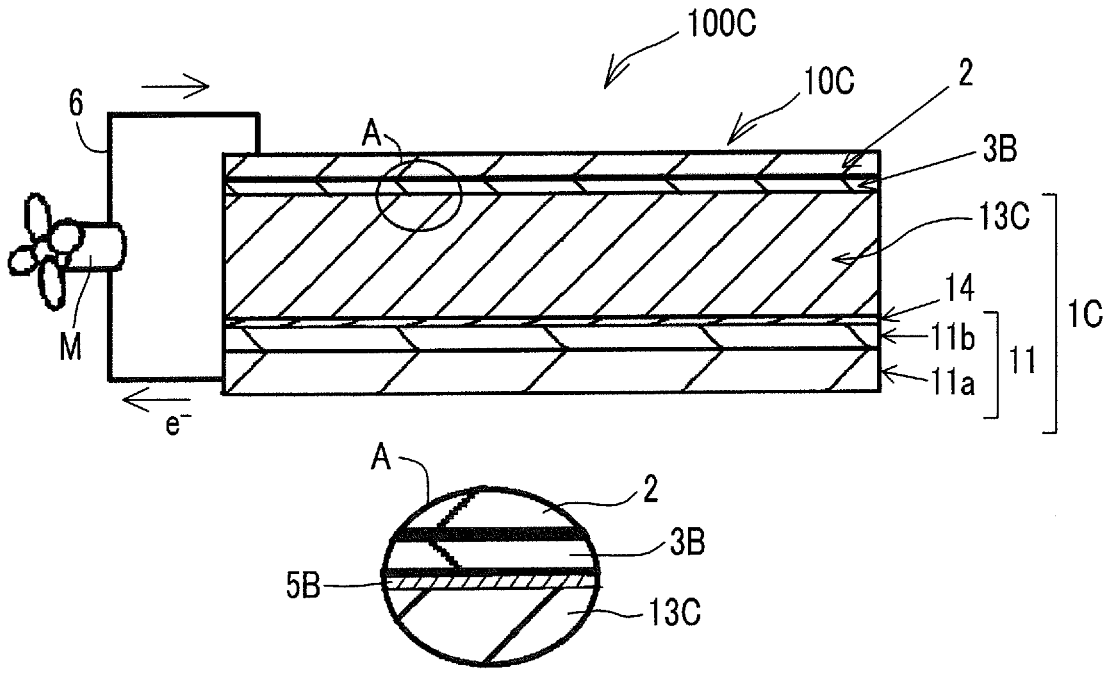
100C
10C
2
3B
6
A
13C
14
1C
11b
11
11a
M
e⁻
A
2
3B
5B
13C

FIG. 4

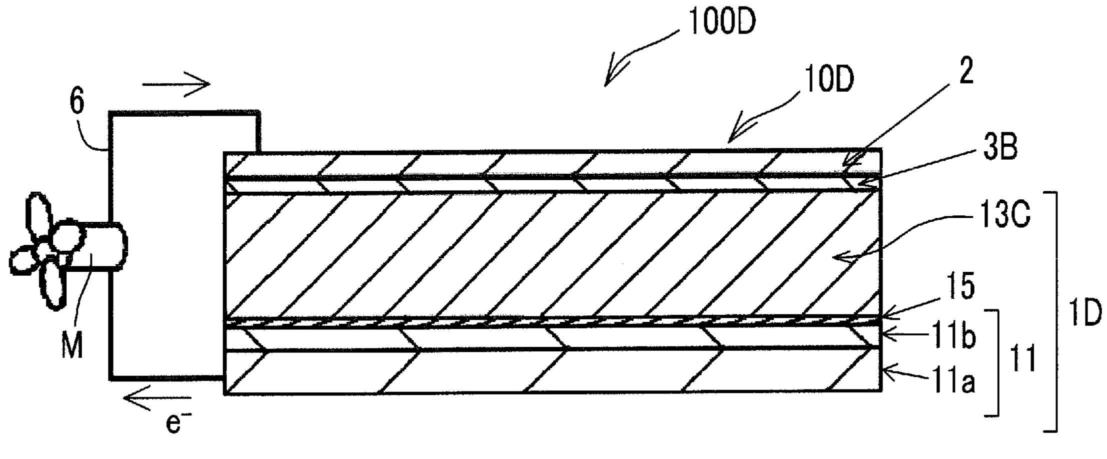
100D
10D
2
3B
6
13C
15
1D
11b
11
11a
M
e⁻

FIG. 5

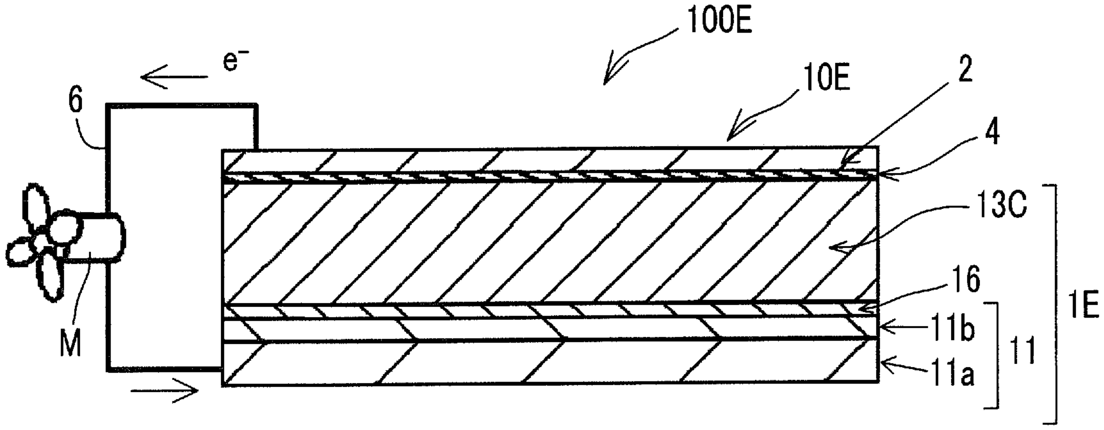
100E
e⁻
10E
2
6
4
13C
16
1E
11b
M
11
11a

FIG. 6

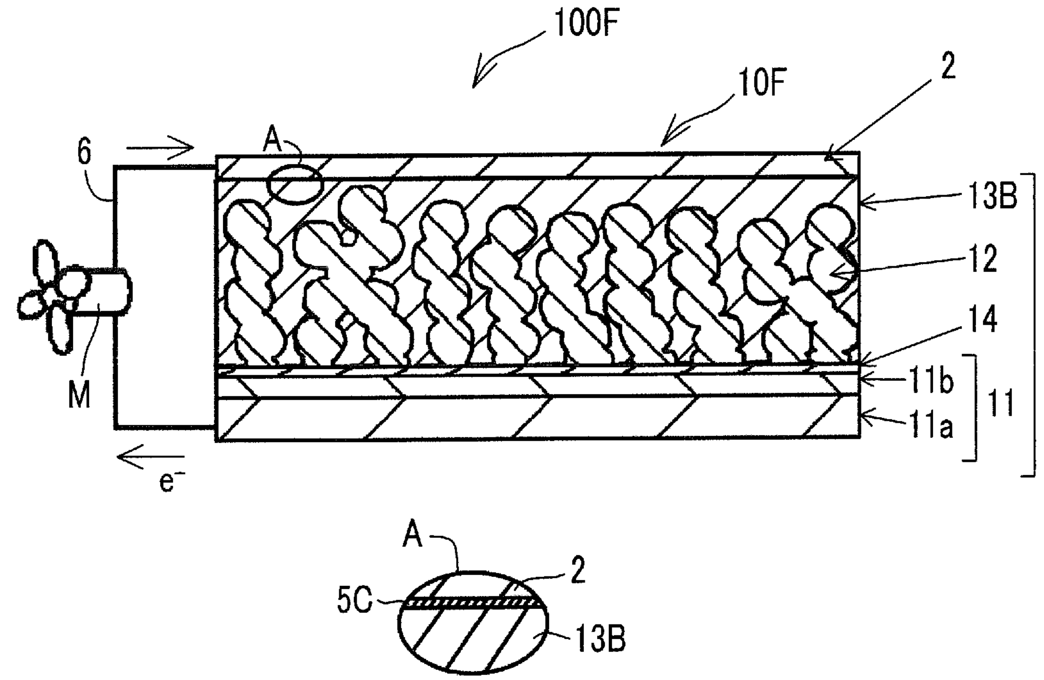
100F
10F
2
6
A
13B
12
14
1F
11b
M
11
11a
e⁻
A
2
5C
13B

**INTERNATIONAL SEARCH REPORT**

International application No. PCT/JP2016/055236

A. CLASSIFICATION OF SUBJECT MATTER
*H01L51/44*(2006.01)i, *H01G9/20*(2006.01)i

According to International Patent Classification (IPC) or to both national classification and IPC

B. FIELDS SEARCHED

Minimum documentation searched (classification system followed by classification symbols)
H01L31/02-31/078, 31/18-31/20, 51/42-51/48, H02S10/00-10/40, 30/00-50/15, 99/00

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2016 |
| Kokai Jitsuyo Shinan Koho | 1971-2016 | Toroku Jitsuyo Shinan Koho | 1994-2016 |

Electronic data base consulted during the international search (name of data base and, where practicable, search terms used)
CAplus/REGISTRY(STN)

C. DOCUMENTS CONSIDERED TO BE RELEVANT

| Category* | Citation of document, with indication, where appropriate, of the relevant passages | Relevant to claim No. |
|---|---|---|
| X | WO 2014/151522 A1 (HUNT ENERGY ENTERPRISES, L.L.C.), 25 September 2014 (25.09.2014), [00173]; fig. 19, 37 (Family: none) | 1,3,6-12 |
| X | WO 2015/016107 A1 (Fujifilm Corp.), 05 February 2015 (05.02.2015), paragraphs [0037] to [0166]; fig. 1 & JP 2016-27587 A & CN 105359289 A & TW 201507186 A & US 2016/0104843 A1 paragraphs [0049] to [0259]; fig. 1 | 1,3-8, 10-12 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 09 May 2016 (09.05.16) | 24 May 2016 (24.05.16) |

| Name and mailing address of the ISA/ | Authorized officer |
|---|---|
| Japan Patent Office<br>3-4-3,Kasumigaseki,Chiyoda-ku,<br>Tokyo 100-8915,Japan | Telephone No. |

Form PCT/ISA/210 (second sheet) (January 2015)

**INTERNATIONAL SEARCH REPORT**

International application No. PCT/JP2016/055236

C (Continuation). DOCUMENTS CONSIDERED TO BE RELEVANT

| Category* | Citation of document, with indication, where appropriate, of the relevant passages | Relevant to claim No. |
|---|---|---|
| A | NOEL.N.K. et al., Enhanced Photoluminescence and Solar Cell Performance via Lewis Base Passivation of Organic-Inorganic Lead Halide Perovskites, ACS Nano, 2014, 8(10), p. 9815-9821, DOI:10.1021/nn5036476 | 1-12 |

Form PCT/ISA/210 (continuation of second sheet) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2001291534 A
- US 4927721 A
- US 4684537 A
- US 5084365 A
- US 5350644 A
- US 5463057 A
- US 5525440 A
- JP 7249790 A
- JP H7249790 A
- JP 2004220974 A
- JP 2008135197 A
- JP 2005135902 A
- JP 2001160425 A
- JP 2003123859 A
- JP 2002260746 A
- JP 2015046440 A


### Non-patent literature cited in the description


- **AKIHIRO KOJIMA ; KENJIRO TESHIMA ; YASUO SHIRAI ; TSUTOMU MIYASAKA.** Organometal Halide Perovskites as Visible-Light Sensitizers for Photovoltaic Cells. *J.Am. Chem. Soc.,* 2009, vol. 131 (17), 6, , 050, , 6, , 051
- *Chemical Review,* 2010, vol. 110, 6595
- *tetrahedron,* 2013, vol. 69 (38), 8191-8198
- *Organic Letters,* 2011, vol. 13 (20), 5464-5467
- *Journal of Agricultural and Food Chemistry,* 2009, vol. 57 (20), 9607-9612
- *Organic and Biomolecular Chemistry,* 2014, vol. 12 (34), 6661-6671
- *Organic Letters,* 2001, vol. 3 (19), 2, , 997-2, 999
- *Journal of Fluorine Chemistry,* 1990, vol. 46 (3), 423-431
- *Tetrahedron Letters,* 2011, vol. 52 (38), 4965-4966
- *European Journal of Organic Chemistry,* 2008, vol. 21, 3668-3672
- *Heterocycles,* 1997, vol. 46 (1), 209-214
- *Chemical Communications,* 2005, vol. 26, 3295-3297